# EUROPÄISCHE PATENTSCHRIFT

(11) **EP 0 487 453 B1**
(45) Veröffentlichungstag und Bekanntmachung des Hinweises auf die Patenterteilung: **22.05.1996**
(21) Anmeldenummer: 91810877.0
(22) Anmeldetag: 13.11.1991
(51) Int. Cl.: C07F 9/53, C07F 9/6596, G03F 7/029, G03F 7/075, C08F 2/50

(54) **Silylierte Acylphosphinoxide**
Silylated acylphosphinoxide
Acylphosphine-oxyde silylée

(30) Priorität: 21.11.1990 CH 3689/90
(43) Veröffentlichungstag der Anmeldung: 27.05.1992
(73) Patentinhaber: CIBA-GEIGY AG, CH-4002 Basel (CH)
(72) Erfinder: Rutsch, Werner, Dr., CH-1700 Fribourg (CH); Hüsler, Rinaldo, Dr., CH-3184 Wünnewil (CH)

(56) Entgegenhaltungen:
- EP-A- 0 007 508
- EP-A- 0 042 567
- EP-A- 0 094 095
- CHEMICAL ABSTRACTS, vol. 68, no. 19, 6. Mai 1968, Columbus, Ohio, US; abstract no. 87343Q, N.F. ORLOV ET AL.: 'Reaction of Triorganylacetoxysilanes with Derivatives of Phosphorus (III)' Seite 8427 ;
- JOURNAL OF THE CHEMICAL SOCIETY. CHEMICAL COMMUNICATION Bd. 20, Nr. 19, 4. Oktober 1978, LETCHWORTH GB Seiten 870 - 871; G.M. BLACKBURN ET AL.: 'Specific Dealkylation of Phosphonate Esters Using Iodotrimethylsilane'

## Beschreibung

Die Erfindung betrifft photohärtbare Zusammensetzungen, die silylierte Acylphosphinoxide enthalten, die Verwendung von silylierten Acylphosphinoxiden als Photoininiatoren zur Photopolymerisation von Verbindungen mit ethylenisch ungesättigten Doppelbindungen und ein Verfahren zur Photopolymerisation solcher Verbindungen mit silylierten Acylphosphinen als Photoinitiatoren, sowie neue silylierte Acylphosphinoxide.

Die EP-B-7 508 und EP-A-42 567 offenbaren unsilylierte Monoacylphosphinoxide als Photoinitiatoren. In der EP-A-184 095 werden Bisacylphosphinoxide als Photoinitiatoren verwendet. Auch die Synthesen und spektroskopische Untersuchungen einiger silylierter Acylphosphinoxide sind schon in der Literatur beschrieben. Beispielsweise kennt man entsprechende Bis(trimethylsilylester) aus Chemical Abstracts 93(13): 132614h; Chemical Abstracts 79(1):5402y und J. Org. Chem. 45(21),4162-7,1980. Bis(triethylsilylester) sind in Chemical Abstracts 78(7):43609h; Chemical Abstracts 78(9):57505h; Chemical Abstracts 80(11):59044x; Chemical Abstracts 78(13):83559y; Chemical Abstracts 75(13):87729q und Chemical Abstracts 78(21): 136372r beschrieben. Entsprechende Monosilylester kennt man aus der SU-193 505. Verbindungen mit zwei unterschiedlichen Silylester-Resten sind in Chemical Abstracts 72(17):90571a und Chemical Abstracts 70(1):4193h beschrieben. Vor allen Dingen sind die silylierten Acylphosphinoxide als Zwischenprodukte bei der Herstellung von Phosphonsäuren und nucleosidischen Phosphonaten bekannt. So sind sie als Zwischenprodukte beispielsweise beschrieben in Rec. Trav. Chim. Pays-Bas 105(11),505-6,1986; Synthesis (8),609-12,1978; J.Chem.Soc.,Chem.Comm.(7),285-6,1978; J.Chem.Soc.,Chem.Comm.(20),870-1,1978; J.Chem.Soc.,Chem.Comm. (17),739,1979; J. Org. Chem. 49(12),2139-43,1984; THL (2),155-8,1977; THL (28),2523-6,1978 und Bull. Chem. Soc. Jp. 51(7),2160-70,1978.

Es wurde nun gefunden, dass sich silylierte Acylphosphinoxide hervorragend als Photoinitiatoren für die Polymerisation von Verbindungen mit ethylenisch ungesättigten Doppelbindungen eignen.

Die Erfindung betrifft also photopolymerisierbare Zusammensetzungen enthaltend
(a) mindestens eine ethylenisch ungesättigte photopolymerisierbare Verbindung und
(b) als Photoinitiator mindestens eine Verbindung der Formel I 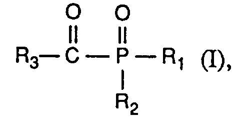 worin
   R₁ für den Rest 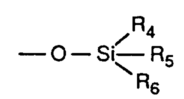 steht,
   R₂ die gleiche Bedeutung wie R₁ hat, wobei R₁ und R₂ in der Bedeutung der Gruppen 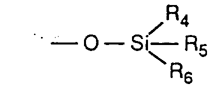 gleich oder verschieden sein können, oder R₂ C₁-C₁₈-Alkyl, durch Phenyl, C₁-C₁₂-Alkoxy oder Halogen substituiertes C₁-C₈-Alkyl, C₂-C₁₈-Alkenyl, unsubstituiertes oder durch C₁-C₁₂-Alkyl, C₁-C₁₂-Alkoxy, Phenyl oder Halogen substituiertes C₅-C₈-Cycloalkyl, unsubstituiertes oder durch Halogen, C₁-C₁₂ -Alkyl oder C₁-C₁₂ -Alkoxy substituiertes C₆-C₁₂ -Aryl, ein aromatischer O-, S- oder/und N-haltiger 5-oder 6-gliedriger heterocyclischer Rest, welcher durch Halogen, C₁-C₄-Alkyl oder C₁-C₄-Alkoxy substituiert sein kann, C₁-C₁₂-Alkoxy, Phenoxy oder Benzyloxy ist und, falls R₂ für einen Rest 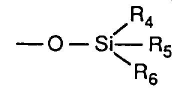 steht, R₆ die Siliziumatome zu 6-, 7- oder 8-gliedrigen Ringen verknüpfen kann, wodurch 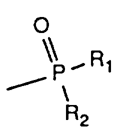 den Gruppen 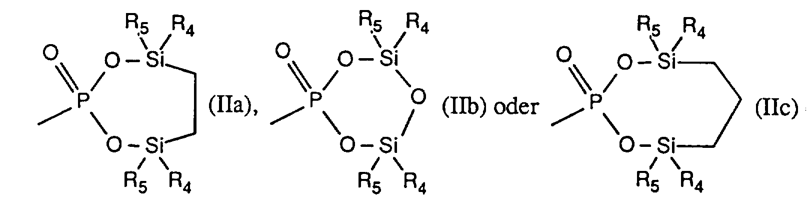 entspricht, oder R₁ und R₂ zusammen mit der -P=O-Gruppe einen 4-gliedrigen Ring der Formel 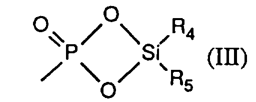 bilden können,
   R₃ C₁-C₁₈-Alkyl, mit Halogen, Phenyl oder C₁-C₁₂-Alkoxy substituiertes C₁-C₈-Alkyl, C₂-C₆-Alkenyl, unsubstituiertes oder durch C₁-C₁₂-Alkyl, C₁-C₁₂-Alkoxy oder Halogen substituiertes C₅-C₈-Cycloalkyl, unsubstituiertes oder durch C₁-C₁₂-Alkyl, C₁-C₁₂-Alkoxy, C₂-C₁₂-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet, und
   R₄, R₅ und R₆ unabhängig voneinander für Wasserstoff, C₁-C₁₈-Alkyl, C₅-C₈-Cycloalkyl, C₁-C₁₂-Alkoxy oder unsubstituiertes oder mit C₁-C₈-Alkyl substituiertes Phenyl stehen, wobei mindestens zwei der Reste R₄, R₅ und R₆ eine andere Bedeutung als Wasserstoff haben.

R₂, R₃, R₄, R₅ und R₆ als C₁-C₁₈-Alkyl können verzweigtes und unverzweigtes Alkyl sein wie z.B. Methyl, Ethyl, Propyl, Isopropyl, n-Butyl, sec-Butyl, tert-Butyl, Pentyl, Hexyl, tert-Hexyl, Heptyl, Octyl, Nonyl, Decyl, Dodecyl, Tetradecyl, Heptadecyl oder Octadecyl. Insbesondere können R₂, R₃, R₄, R₅ und R₆ für C₁-C₁₂-Alkyl stehen.

R₂ und R₃ als ein- oder mehrfach, z.B. ein bis 3-fach, insbesondere ein- oder zweifach, substituiertes C₁-C₈-Alkyl können z.B. Benzyl, 1-Phenylethyl, 2-Phenylethyl, α,α-Dimethylbenzyl, 2-Methoxyethyl, 2-Ethoxyethyl, 2-Butoxyethyl, 2-Isopropoxyethyl, 2-Butoxypropyl, 2-Octyloxyethyl, Chlormethyl, 2-Chlorethyl oder Trichlormethyl, bevorzugt Benzyl, sein.

R₂ als C₂-C₁₈-Alkenyl kann z.B. Allyl, Methallyl, 1,1-Dimethylallyl, Butenyl, 2-Hexenyl, Octenyl, Undecenyl, Dodecenyl oder Octadecenyl sein.
R₃ als C₂-C₆-Alkenyl kann z.B. Vinyl, Propenyl oder Butenyl sein.

R₂ und R₃ als C₅-C₈-Cycloalkyl können z.B. Cyclopentyl, Cyclohexyl oder Cyclooctyl sein. Als substituiertes, z.B. 1- bis 4-fach substituiertes, C₅-C₈-Cycloalkyl können sie z.B Methylcyclopentyl, Dimethylcyclopentyl, Methylcyclohexyl, Dimethylcyclohexyl, Diethylcyclohexyl, Methoxycyclohexyl, Dimethoxycyclohexyl, Diethoxycyclohexyl, Phenylcyclopentyl, Phenylcyclohexyl, Chlorcyclohexyl, Dichlorcyclohexyl oder Dichlorcyclopentyl sein.

R₂ und R₃ als C₆-C₁₂-Aryl können z.B. Phenyl, α-Naphthyl, β-Naphthyl oder 4-Diphenylyl, bevorzugt Phenyl, sein. R₂ und R₃ als substituiertes C₆-C₁₂-Aryl enthält vorzugsweise 1 bis 3 Substituenten und ist z.B. Chlorphenyl, Dichlorphenyl, Trichlorphenyl, Difluorphenyl, Tolyl, Mesityl, Ethylphenyl, tert-Butylphenyl, Dodecylphenyl, Methoxyphenyl, Dimethoxyphenyl, Ethoxyphenyl, Hexyloxyphenyl, Methylnaphthyl, Isopropylnaphthyl, Chlomaphthyl oder Ethoxynaphthyl, insbesondere Chlorphenyl und Mesityl, sein. R₃ als substituiertes Aryl kann darüber hinaus auch z.B. Methoxyethylphenyl, Ethoxymethylphenyl, Methylthiophenyl, Isopropylthiophenyl oder tert-Butylthiophenyl sein. Alkyl und Alkoxy als Arylsubstituenten haben vorzugsweise 1 - 4 C-Atome und sind insbesondere Methyl oder Methoxy.

R₂ und R₃ als heterocyclischer Rest können ein- oder mehrkernig, insbesondere ein- oder zweikernig sein, beispielsweise mit annelliertem Benzolring, und bedeuten z.B. Furyl, Thienyl, Pyrryl, Pyridyl, Indolyl, Benzoxazolyl, Benzimidazolyl oder Benzthiazolyl. Bevorzugt enthält ein solcher heterocyclischer Rest 4-12 C-Atome. Die genannten heterocyclischen Reste können ein- oder mehrfach, z.B. ein- oder zweifach, substituiert sein. Beispiele dafür sind Dimethylpyridyl, Methylchinolyl, Dimethylpyrryl, Methoxyfuryl, Dimethoxypyridyl oder Difluorpyridyl.

R₂, R₄, R₅ und R₆ als C₁-C₁₂-Alkoxy bedeuten beispielsweise Methoxy, Ethoxy, Propoxy, Butoxy, Dodecoxy.

R₄, R₅ und R₆ als mit C₁-C₈-Alkyl substituiertes Phenyl enthalten vorzugsweise 1 bis 3, insbesondere 1 oder 2 Alkylsubstituenten und bedeuten beispielsweise Tolyl, Xylyl, Mesityl oder Ethylphenyl.

Halogen bedeutet vorzugsweise Chlor.

Bevorzugt sind Zusammensetzungen, worin R₂ die gleiche Bedeutung hat wie R₁, wobei R₁ und R₂ in der Bedeutung der Gruppen 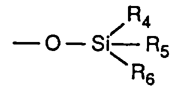 gleich oder verschieden sein können, oder R₂ für C₁-C₁₂-Alkyl, durch Phenyl, C₁-C₄- Alkoxy oder Halogen substituiertes C₁-C₈-Alkyl, C₂-C₈-Alkenyl, unsubstituiertes oder durch C₁-C₄-Alkyl, C₁-C₄-Alkoxy, Phenyl oder Halogen substituiertes C₅-C₈-Cycloalkyl, unsubstituiertes oder durch Halogen, C₁-C₈-Alkyl oder C₁-C₄-Alkoxy substituiertes C₆-C₁₂ -Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, C₁-C₈-Alkoxy, Phenoxy oder Benzyloxy steht, und, falls R₂ für einen Rest 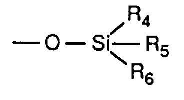 steht, R₆ die Siliziumatome zu 6-, 7- oder 8-gliedrigen Ringen verknüpfen kann, wodurch 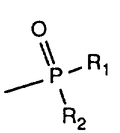 den Gruppen IIa, IIb oder IIc entsprechen kann, oder R₁ und R₂ zusammen mit der -P=O-Gruppe einen Ring der Formel III bilden können, R₃ C₁-C₁₂-Alkyl, mit Halogen, C₁-C₄-Alkoxy oder Phenyl substituiertes C₁-C₈-Alkyl, C₂-C₄-Alkenyl, unsubstituiertes oder durch C₁-C₈-Alkyl, C₁-C₄-Alkoxy oder Halogen substituiertes C₅-C₈-Cycloalkyl, unsubstituiertes oder durch C₁-C₈-Alkyl, C₁-C₈-Alkoxy, C₂-C₈-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet und R₄, R₅ und R₆ unabhängig voneinander für Wasserstoff, C₁-C₁₂-Alkyl,
C₅-C₈-Cycloalkyl, C₁-C₄-Alkoxy oder unsubstituiertes oder mit C₁-C₄-Alkyl substituiertes Phenyl stehen.

Weiterhin bevorzugt sind Zusammensetzungen, worin R₂ die gleiche Bedeutung hat wie R₁, wobei R₁ und R₂ in der Bedeutung der Gruppen 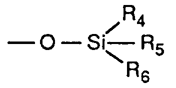 gleich oder verschieden sein können, oder R₂ für C₁-C₁₂-Alkyl, durch Phenyl substituiertes C₁-C₈-Alkyl, C₅-C₈-Cycloalkyl, C₆-C₁₂-Aryl oder C₁-C₈-Alkoxy steht. und. falls R₂ für einen Rest 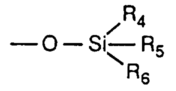 steht, R₆ die Siliziumatome zu einem 7-gliedrigen Ring verknüpfen kann, wodurch 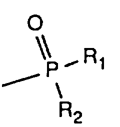 der Gruppe IIa entspricht,
R₃ C₁-C₁₂-Alkyl, mit Halogen substituiertes C₁-C₈-Alkyl, unsubstituiertes oder durch C₁-C₈-Alkyl substituiertes C₅-C₈-Cycloalkyl oder unsubstituiertes oder durch C₁-C₈-Alkyl, C₁-C₈-Alkoxy oder Halogen substituiertes C₆-C₁₂-Aryl bedeutet und R₄, R₅ und R₆ unabhängig voneinander für Wasserstoff, C₁-C₁₂-Alkyl, C₅-C₈-Cycloalkyl, oder unsubstituiertes oder mit C₁-C₄-Alkyl substituiertes Phenyl stehen.

Eine weitere bevorzugte Ausführungsform der Erfindung sind Zusammensetzungen, worin R₂ die gleiche Bedeutung wie R₁ hat, wobei R₁ und R₂ in der Bedeutung der Gruppen 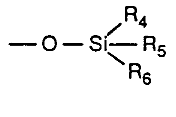 gleich oder verschieden sein können, oder R₂ für Phenyl, C₁-C₄-Alkoxy, unsubstituiertes oder durch Phenyl substituiertes C₁-C₄-Alkyl steht, oder, falls R₂ für einen Rest 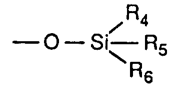 steht, R₆ die Siliziumatome zu einem Ring verknüpfen kann, wodurch 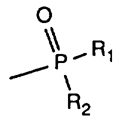 der Gruppe IIa entspricht, R₃ unsubstituiertes oder durch Halogen substituiertes C₁-C₄-Alkyl, unsubstituiertes oder durch C₁-C₆-Alkyl, C₁-C₄-Alkoxy oder Halogen substituiertes Phenyl bedeutet und R₄, R₅ und R₆ unabhängig voneinander für Wasserstoff, C₁-C₈-Alkyl, C₅-C₈-Cycloalkyl oder Phenyl stehen.

Ausserdem sind Zusammensetzungen bevorzugt, worin R₂ die gleiche Bedeutung wie R₁ hat, wobei R₁ und R₂ in der Bedeutung der Gruppen 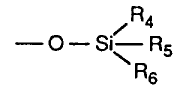 gleich oder verschieden sein können, oder R₂ für Phenyl steht, und, falls R₂ für einen Rest 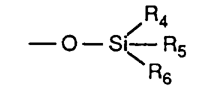 steht, R₆ die Siliziumatome zu einem 7-gliedrigen Ring verknüpfen kann, wodurch 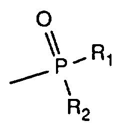 der Gruppe IIa entspricht, R₃ unsubstituiertes oder durch Halogen substituiertes C₁-C₄-Alkyl oder unsubstituiertes oder durch C₁-C₆-Alkyl,
C₁-C₄-Alkoxy oder Halogen substituiertes Phenyl bedeutet und R₄, R₅ und R₆ unabhängig voneinander für C₁-C₈-Alkyl oder Phenyl stehen.

Erfindungsgemäss sind auch Zusammensetzungen, die neben dem Photoinitiator (b) noch mindestens einen weiteren Photoinitiator und/oder andere Additive enthalten.

Die photopolymerisierbaren Zusammensetzungen enthalten den Photoinitiator (b) zweckmässig in einer Menge von 0,05 bis 15 Gew.-%, vorzugsweise 0,2 bis 5 Gew.-%, bezogen auf die Zusammensetzung.

Gegenstand der Erfindung sind auch Verbindungen der Formel Ia, die als Photoinitiatoren für die Polymerization von Verbindungen mit ethylenisch ungesättigten Doppelbindungen geeignet sind 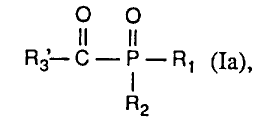 worin,
R₁ für den Rest 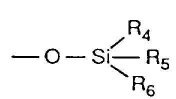 steht,
R₂ die gleiche Bedeutung wie R₁ hat, R₁ und R₂ in der Bedeutung der Gruppen 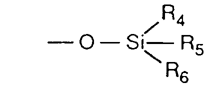 gleich oder verschieden sein können, oder R₂ C₁-C₁₈-Alkyl, durch Phenyl, C₁-C₁₂-Alkoxy oder Halogen substituiertes C₁-C₈-Alkyl, C₂-C₁₈-Alkenyl, unsubstituiertes oder durch C₁-C₁₂-Alkyl, C₁-C₁₂-Alkoxy, Phenyl oder Halogen substituiertes C₅-C₈-Cycloalkyl, unsubstituiertes oder durch Halogen, C₁-C₁₂-Alkyl oder C₁-C₁₂-Alkoxy substituiertes C₆-C₁₂-Aryl, ein aromatischer O-, S- oder/und N-haltiger 5-oder 6-gliedriger heterocyclischer Rest, welcher durch Halogen, C₁-C₄-Alkyl oder C₁-C₄-Alkoxy substituiert sein kann, oder Benzyloxy ist und, falls R₂ für einen Rest 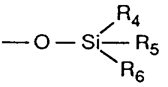 steht, R₆ die Siliziumatome zu 6-, 7- oder 8-gliedrigen Ringen verknüpfen kann, wodurch 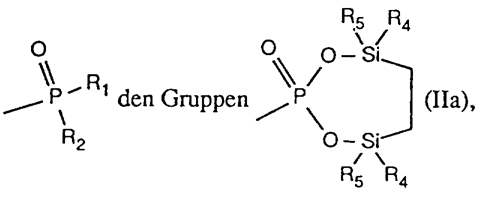 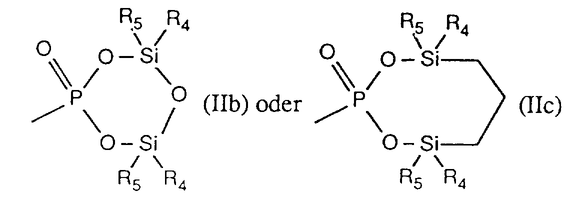 entspricht, oder R₁ und R₂ zusammen mit der -P=O-Gruppe einen 4-gliedrigen Ring der Formel 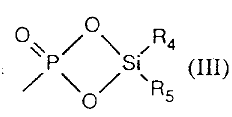 bilden können,
R₃' C₁-C₁₈-Alkyl, mit Halogen, oder C₁-C₁₂-Alkoxy substituiertes C₁-C₈-Alkyl, C₂-C₆-Alkenyl, unsubstituiertes oder durch C₁-C₁₂-Alkyl, C₁-C₁₂-Alkoxy oder Halogen substituiertes C₅-C₈-Cycloalkyl, unsubstituiertes oder durch C₁-C₁₂-Alkyl,
   C₁-C₁₂-ACkoxy, C₂-C₁₂-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet, und
R₄, R₅ und R₆ unabhängig voneinander für Wasserstoff, C₁-C₁₈-Alkyl, C₅-C₈-Cycloalkyl, C₁-C₁₂-ASoxy oder unsubstituiertes oder durch C₁-C₈-Alkyl substituiertes Phenyl stehen, wobei mindestens zwei der Reste R₄, R₅ und R₆ eine andere Bedeutung als Wasserstoff haben,
mit den Massgaben, dass, (1) wenn R₁ und R₂ gleich sind und R₄, R₅ und R₆ die gleiche Bedeutung haben und für Methyl oder Ethyl stehen, R₃' nicht C₁-C₅-Alkyl, Phenyl, Methyl-, Methoxy- oder Halogenphenyl ist, und (2) wenn R₃' für Methyl steht R₄, R₅ und R₆ im Rest R₁ nicht gleichzeitig Ethyl bedeuten.

Bevorzugt sind solche Verbindungen der Formel Ia, worin R₂ die gleiche Bedeutung wie R₁ hat, wobei R₁ und R₂ in der Bedeutung der Gruppen 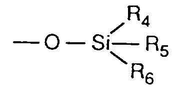 gleich oder verschieden sein können, oder R₂ für C₁-C₁₂-Alkyl, durch Phenyl, C₁-C₄- Alkoxy oder Halogen substituiertes C₁-C₈-Alkyl, C₂-C₈-Alkenyl, unsubstituiertes oder durch C₁-C₄-Alkyl, C₁-C₄-Alkoxy, Phenyl oder Halogen substituiertes C₅-C₈-Cycloalkyl, unsubstituiertes oder durch Halogen, C₁-C₈-Alkyl oder C₁-C₄-Alkoxy substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, oder Benzyloxy steht, und, falls R₂ für einen Rest 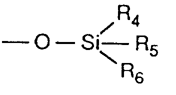 steht, R₆ die Siliziumatome zu 6-, 7- oder 8-gliedrigen Ringen verknüpfen kann, wodurch 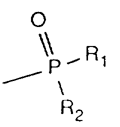 den Gruppen IIa, IIb oder Ilc entsprechen kann, oder R₁ und R₂ zusammen mit der -P=O-Gruppe einen Ring der Formel III bilden können, R₃' C₁-C₁₂-Alkyl, mit Halogen, oder C₁-C₄-Alkoxy substituiertes C₁-C₈-Alkyl, C₂-C₄-Alkenyl, unsubstituiertes oder durch C₁-C₈-Alkyl, C₁-C₄-Alkoxy oder Halogen substituienes C₅-C₈-Cycloalkyl, unsubstituiertes oder durch C₁-C₈-Alkyl, C₁-C₈-Alkoxy, C₂-C₈-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet und R₄, R₅ und R₆ unabhängig voneinander für Wasserstoff, C₁-C₁₂-Alkyl, C₅-C₈-Cycloalkyl, C₁-C₄-Alkoxy oder unsubstituiertes oder mit C₁-C₄-Alky- substituiertes Phenyl stehen.

Ebenfalls bevorzugt sind Verbindungen der Formel Ia, worin R₂ die gleiche Bedeutung hat wie R₁, wobei R₁ und R₂ in der Bedeutung der Gruppen 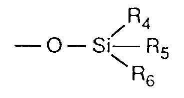 gleich oder verschieden sein können, oder R₂ für C₁-C₁₂-Alkyl, durch Phenyl substituiertes C₁-C₈-Alkyl, C₅-C₈-Cycloalkyl, oder C₆-C₁₂-Aryl steht, und, falls R₂ für einen Rest 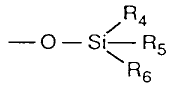 steht, R₆ die Siliziumatome zu einem 7-gliedrigen Ring verknüpfen kann, wodurch 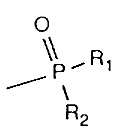 der Gruppe IIa entspricht,
R₃' C₁-C₁₂-Alkyl, mit Halogen substituiertes C₁-C₈-Alkyl, unsubstituiertes oder durch C₁-C₈-Alkyl substituiertes C₅-C₈-Cycloalkyl oder unsubstituiertes oder durch C₁-C₈-Alkyl, C₁-C₈-Alkoxy oder Halogen substituiertes C₆-C₁₂-Aryl bedeutet und R₄, R₅ und R₆ unabhängig voneinander für Wasserstoff, C₁-C₁₂-Alkyl, C₅-C₈-Cycloalkyl, C₁-C₄-Alkoxy oder unsubstituiertes oder mit C₁-C₄-Alkyl substituiertes Phenyl stehen.

Eine weitere bevorzugte Ausführungsform sind Verbindungen der Formel Ia, worin R₂ die gleiche Bedeutung wie R₁ hat, wobei R₁ und R₂ in der Bedeutung der Gruppen 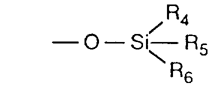 gleich oder verschieden sein können, oder R₂ für unsubstituiertes oder durch Phenyl substituiertes C₁-C₄-Alkyl, oder Phenyl steht, oder, falls R₂ für einen Rest 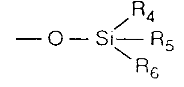 steht, R₆ die Siliziumatome zu einem 7-gliedrigen Ring verknüpfen kann, wodurch 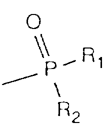 der Gruppe IIa entspricht, R₃' unsubstituiertes oder durch Halogen substituiertes C₁-C₄-Alkyl, unsubstiuiertes oder durch C₁-C₆-Alkyl,
C₁-C₄-Alkoxy oder Halogen substituiertes Phenyl bedeutet und R₄, R₅ und R₆ unabhängig voneinander für Wasserstoff, C₁-C₈-Alkyl oder Phenyl stehen.

Ausserdem bevorzugt sind Verbindungen, worin R₂ die gleiche Bedeutung wie R₁ hat, wobei R₁ und R₂ in der Bedeutung der Gruppen 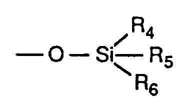 gleich oder verschieden sein können, oder R₂ für Phenyl steht, oder, falls R₂ für einen Rest 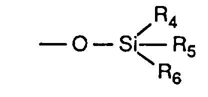 steht, R₆ die Siliziumatome zu einem 7-gliedrigen Ring verknüpfen kann, wodurch 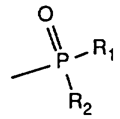 der Gruppe IIa entspricht, R₃' durch Halogen substituiertes C₁-C₄-Alkyl oder unsubstituiertes oder durch C₁-C₆-Alkyl oder Halogen substituiertes Phenyl bedeutet und R₄, R₅ und R₆ unabhängig voneinander für C₁-C₈-Alkyl oder Phenyl stehen.

Beispiele für einzelne Verbindungen der Formel I sind:
2,4,6-Trimethylbenzoyl-phosphonsäure-bis(trimethylsilyl)ester
2,6-Dichlorbenzoyl-phosphonsäure-methyl-trimethylsilyl-ester
2,6-Dimethoxybenzoyl-phenylphosphinsäure-dimethyl-tert-hexylsilylester Pivaloyl-iso-butylphosphinsäure-diphenylmethylsilylester
2,4,6-Trimethylbenzoyl-phosphonsäure-ethyl-cyclohexyldimethylsilylester
2,6-Dimethoxybenzoyl-benzylphosphinsäure-trimethylsilylester
2-Ethoxybenzoyl-phosphonsäure-bis(diethylsilyl)ester
2,2-Bis(chlormethyl)propionyl-phosphonsäure-bis(dimethylphenylsilylester)

Die Herstellung der Verbindungen der Formel I kann nach an sich bekannten Verfahren erfolgen, solche sind etwa in den eingangs zitierten Literaturstellen beschrieben, worin auch die bereits bekannten Verbindungen der Formel I offenbart sind.

Die Verbindungen der Formel I können, wie z.B. in THL (2), 155-8,1977 beschrieben, aus den entsprechenden Alkylestern von Monoacylphosphinoxiden durch Umesterung mit Trialkylchlorsilan erhalten werden:

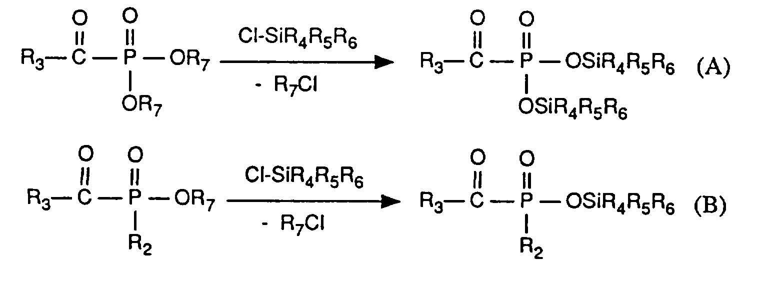

R₇ steht für Alkyl oder Aryl. Die anderen Reste sind wie oben und in den Ansprüchen definiert. Je nach stöchiometrischem Verhältnis der Reaktanden lassen sich nach (A) auch die Monosilylester-monoalkylester-Verbindungen herstellen.
Des weiteren kann das Trialkylchlorsilan durch Trialkylbrom- oder -iodsilan ersetzt werden, wie beispielsweise in Synthesis (8), 609-12, 1978 beschrieben.

Eine weitere Möglichkeit zur Synthese der Verbindungen der Formel I bietet die Michaelis-Arbusov-Reaktion, wobei ein Säurechlorid mit einem Tris(trialkylsilyl)phosphin umgesetzt wird, wie beispielsweise in der EP-A-0 042 567 beschrieben:

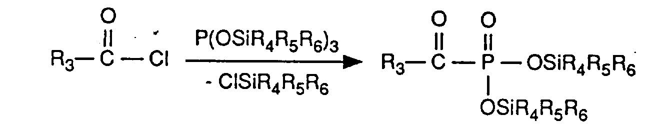

Wird anstelle des Tris(trialkylsilyl)phosphins beispielsweise eine Verbindung der Formel 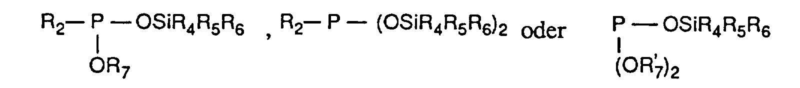 verwendet, können Verbindungen wie 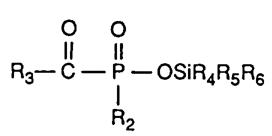 und 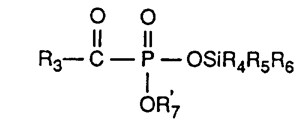 erhalten werden, wobei R₇′ für C₁-C₁₂ -Alkyl, Phenyl oder Benzyl steht.
Auch die Verbindungen, die cyclische Strukturen der Formeln IIa, IIb, IIc und III enthalten, können durch die Michaelis-ArbusovReaktion hergestellt werden.

Die Herstellung der Ausgangsprodukte ist allgemein bekannt und dem Fachmann geläufig. Die Monoacylphosphinoxid-Edukte von (A) und (B) lassen sich beispielsweise durch Michaelis-Arbusov-Reaktion der entsprechenden Phosphonite [erhältlich aus den Chlorphosphinen durch Umsetzung mit Alkoholen; vgl. Houben-Weyl, Methoden d. Org. Chemie XII/1, 324-327 (1963),G. Thieme Verlag, Stuttgart] mit Säurechloriden herstellen. Die Synthese von Tris(trialkylsilyl)phosphinen und ihrer Derivate ist ebenfalls allgemein bekannt. Sie kann z.B. durch Umesterung von P(OR)₃ mit Trialkylsilylchlorid erfolgen [Vgl. J. Org. Chem. 28, 2975 (1963)].

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Als Komponente (a) kommen solche ethylenisch ungesättigten monomeren, oligomeren und polymeren Verbindungen in Frage, die durch Photopolymerisation zu höhermolekularen Produkten reagieren und hierbei ihre Löslichkeit verändern.

Die ungesättigten Verbindungen können eine oder mehrere olefinische Doppelbindungen enthalten. Sie können niedermolekular (monomer) oder höhermolekular (oligomer) sein.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien-Copolymere, Polyisopren und Isopren-Copolymere, Polymere und Copolymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4′-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Tri-ethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.

Als Komponente (a) können auch silylierte Harze, wie beispielsweise Polysiloxane mit Acrylatfunktionen verwendet werden.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)ethan. Weitere geeignete Polyamine sind Polymere und Copolymere mit gegebenfalls zusätzlichen Aminogruppen in der Seitenkette und Oligoamide mit Aminoendgruppen.

Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Polyvinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 50-90 Gew.-% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000-1 000 000. Beispiele sind: homo- und copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die vor allem während der Herstellung der Zusammensetzungen durch Mischen der Komponenten, eine vorzeitige Polymerisation verhindern sollen, wie z.B. Hydrochinon, Hydrochinonderivate, p-Methoxyphenol, β-Naphtol oder sterisch gehinderte Phenole wie z.B. 2,6-Di(tert-butyl)-p-kresol.
Zur Erhöhung der Dunkellagerstabilität können z.B. Kupferverbindungen, wie Kupfernaphtenat, -stearat, oder -octoat, Phosphorverbindungen, wie z.B. Triphenylphosphin, Tributylphosphin, Triethylphosphit, Triphenylphosphit oder Tribenzylphosphit, quarternäre Ammoniumverbindungen, wie z.B. Tetramethylammoniumchlorid oder Trimethyl-benzylammoniumchlorid, oder Hydroxylaminderivate, wie z.B. N-Diethylhydroxylamin, verwendet werden.
Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den Zutritt von Luft verhindert.
Als Lichtschutzmittel können in geringer Menge UV-Absorber, wie z.B. solche vom Benztriazol-, Benzophenon- oder Oxalanilid-Typ, zugesetzt werden. Ebenso lassen sich Lichtschutzmittel vom Typus sterisch gehinderter Amine (HALS) zusetzen.

In bestimmten Fällen kann es von Vorteil sein, Gemische von zwei oder mehr der erfindungsgemässen Photoinitiatoren zu verwenden. Selbstverständlich können auch Gemische mit bekannten Photoinitiatoren verwendet werden, z.B. Gemische mit Initiatoren vom Typ der Benzophenone, Acetophenonderivate, wie beispielsweise α-Hydroxycycloalkylphenylketone, α-Aminoketone, Benzoinalkylether und Benzilketale, oder vom Typ der unsilylierten Acylphosphinoxide oder Titanocene.

Zur Beschleunigung der Photopolymerisation, vor allem in pigmentierten Zubereitungen, können Amine zugesetzt werden, wie z.B. Triethanolamin, N-Methyl-diethanolamin, p-Dimethylaminobenzoesäure-ethylester oder Michler's Keton. Die Wirkung der Amine kann verstärkt werden durch den Zusatz von aromatischen Ketonen vom Typ des Benzophenons.

Eine Beschleunigung der Photopolymerisation kann weiterhin durch Zusatz von Photosensibilisatoren geschehen, welche die spektrale Empfindlichkeit verschieben bzw. verbreitem. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline.

Weitere übliche Zusätze sind z.B. - je nach Verwendungszweck - Füllstoffe, Pigmente, Farbstoffe, Haft-, Netz- oder Verlaufhilfsmittel.

Die photopolymerisierbaren Zusammensetzungen können für verschiedene Zwecke verwendet werden, beispielsweise als Druckfarbe, als Klarlack, als Weisslack, als Anstrichstoff, als Anstrichstoff für Aussenanstriche, für photographische Reproduktionsverfahren, für Bildaufzeichnungsverfahren oder zur Herstellung von Druckplatten, als Zahnfüllmassen, als Klebstoffe, als Ueberzüge von optischen Fasern, für gedruckte Schaltungen oder zur Beschichtung von elektronischen Teilen.

In Lacken verwendet man häufig Zweikomponeten-Gemische eines Prepolymeren mit einem mehrfach ungesättigten Monomeren oder Dreikomponenten-Gemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die erfindungsgemässen photohärtbaren Zusammensetzungen eignen sich als Beschichtungsmittel für Substrate aller Art, z.B. Holz, Papier, Keramik, Kunststoffe wie Polyester und Celluloseacetatfilme und Metalle wie Kupfer und Aluminium, bei denen durch Photopolymerisation eine Schutzschicht oder eine Abbildung aufgebracht werden soll.
Die Beschichtung der Substrate kann erfolgen, indem man eine flüssige Zusammensetzung, eine Lösung oder Suspension auf das Substrat aufbringt. Das geschieht z.B. durch Tauchen, Aufpinseln, Spritzen oder Reverseroll-Beschichtung. Die Auftragsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 µm. Bei Mitverwenden von Lösungsmitteln werden diese nach dem Beschichten entfernt.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll.

Insbesondere für den Siebdruck sind UV-härtbare Druckfarben von Bedeutung.

Gut geeignet sind die erfindungsgemässen photohärtbaren Gemische auch zur Herstellung von Druckplatten. Hierbei werden z.B. Gemische von löslichen linearen Polyamiden oder Styrol/Butadien Kautschuk mit photopolymerisierbaren Monomeren, beispielsweise Acrylamiden, und einem Photoinitiator verwendet. Filme und Platten aus diesen Systemen (nass oder trocken) werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung von photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Gegenstand der Erfindung ist auch ein Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen eine Verbindung der Formel I zugibt und mit Licht im Bereich von 200 bis 600 nm bestrahlt.

Die Polymerisation erfolgt nach den bekannten Methoden der Photopolymerisation durch Bestrahlung mit Sonnenlicht oder mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 250 und 450 nm liegen. Laserlichtquellen haben den Vorteil, dass keine Photomasken notwendig sind, da der gesteuerte Laserstrahl direkt auf die photohärtbare Schicht schreibt. Im Falle einer Kombination mit Photosensibilisatoren können auch längerwelliges Licht oder Laserstrahlen bis 600 nm verwendet werden.

Die Zusammensetzungen werden durch Mischen der einzelnen Komponenten hergestellt.

Die erfindungsgemässen Verbindungen zeichnen sich durch eine gute Löslichkeit in den üblicherweise verwendeten Harzen aus. Ebenso ist die Löslichkeit und Verträglichkeit in silylierten Harzen, d.h. Polysiloxanen mit Acrylatfunktionen, hervorzuheben.
Die Zusammensetzungen enthaltend Verbindungen der Formel I weisen gute Lagerstabilitäten auf.
Die Einarbeitung der Verbindungen der Formel I in Lacke führt zu geruchsarmen Lacken mit geringer Vergilbung.

Die nachfolgenden Beispiele erläutern die Erfindung weiter. Angaben in Teilen oder Prozenten beziehen sich, ebenso wie in der übrigen Beschreibung und den Patentansprüchen, auf das Gewicht, sofern nichts anderes angegeben ist.

### Beispiel 1: Herstellung von

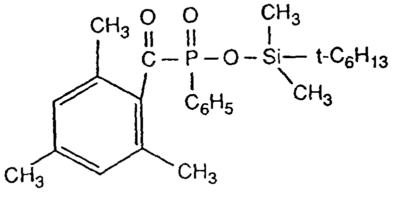

t-C₆-H₁₃ bedeutet 1,1,2,2-Tetramethylethyl.
6,0 g (0,02 mol) 2,4,6-Trimethylbenzoyl-phenyl-phosphinsäuremethylester und 4,3 g (0,024 mol) tert-Hexyldimethylchlorsilan werden unter Rühren auf 160 °C erwärmt und bei dieser Temperatur 3 Stunden nachgerührt, wobei das entstehende Methylchlorid in einer Kühlfalle aufgefangen wird. Nach dem Abkühlen wird der Rückstand am Hochvakuum-Kugelrohr destilliert (Siedepunkt 170 °C/0,1 mbar). Man erhält 5,9 g (68,8% d.Theorie) der Titelverbindung als klares gelbliches Oel.

| | | | |
|---|---|---|---|
| Elementaranalyse: | ber.: | C 66,94 % | H 8,19 % |
| | gef.: | C 66,62 % | H 8,20 % |

### Beispiel 2 - 7:

Die Verbindungen der Beispiele 2 - 7 werden in analoger Weise zu der Verbindung aus Beispiel 1 hergestellt.
Die Strukturen und physikalischen Daten sind der Tabelle 1 zu entnehmen.

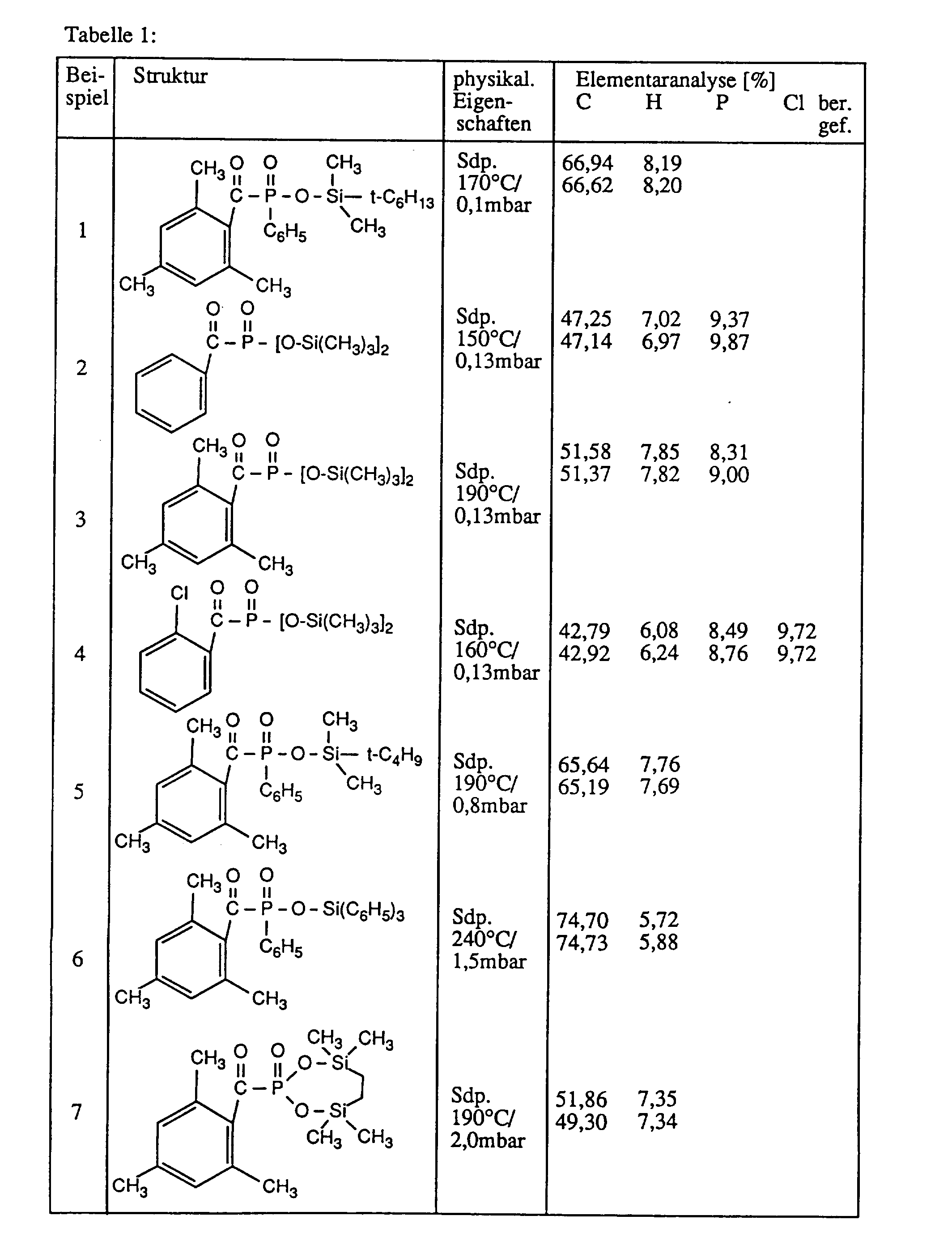

### Beispiel 8: Herstellung von

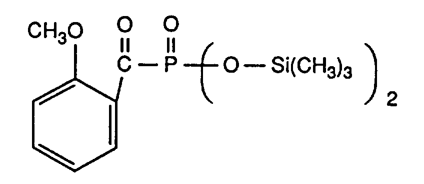

Zu einer Lösung aus 4,8 g (0,028 mol) 2-Methoxybenzoylchlorid in 100 ml Toluol werden bei 80 °C unter Stickstoff innerhalb von 20 min. 8,7 g (0,029 mol) Tris(trimethylsilyl)-phosphit getropft. Nach 3 h Rühren bei 80 °C wird die gelbliche Lösung auf Raumtemperatur abkühlen lassen und am Rotationsverdampfer eingeengt. Zur Reinigung wird der Rückstand destilliert. Man erhält 4,0 g (40 % d. Theorie) der Titelverbindung als leicht gelbes Oel mit einem Siedepunkt von 118 °C/2 mbar.

| | | | |
|---|---|---|---|
| Elementaranalyse: | ber.: | C 46,65 % | H 6,99 % |
| | gef.: | C 46,42 % | H 7,40 % |

### Beispiele 9-11:

Die Verbindungen der Beispiele 9-11 werden durch Verwendung der entsprechenden Säurechloride analog zu der Verbindung des Beipiels 8 hergestellt.
Die Verbindungen, sowie die Elementaranalysen der Oele, sind der folgenden Tabelle 2 zu entnehmen.

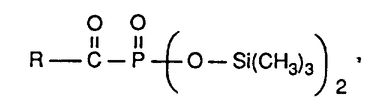

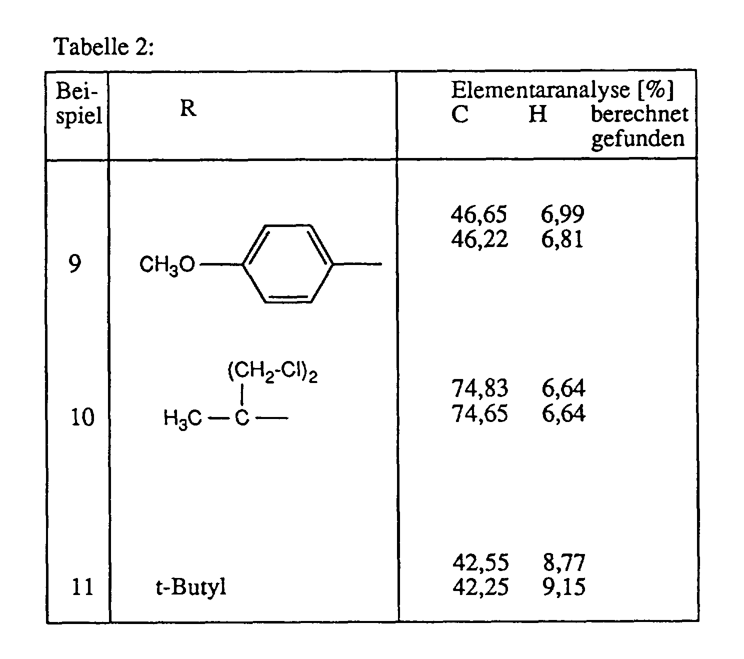

### Beispiel 12:

Initiator-Reaktivität in einem Klarlack
Es wird eine photopolymerisierbare Zusammensetzung bereitet aus
- 99,5 Teilen: ®Roskydal UV 502 A (Lösung eines ungesättigten Polyesters in Styrol; BAYER, BRD)
- 0,5 Teilen: ®BYK 300 (Verlaufhilfsmittel; Byk-Mallinckrodt)

Zu dieser Zusammensetzung werden 2 Gew.-% des zu prüfenden Photoinitiators gemischt. Die Formulierung wird in einer Schichtdicke von 100 µm auf Spanplatten, die mit weissem Kunstharz beschichtet sind, aufgetragen. Die Proben werden dann in einem PPG-Bestrahlungsgerät mit Quecksilbermitteldrucklampen (2 X 80 W/cm) bestrahlt. Dabei wird die Probe so oft auf einem Band, welches mit einer Geschwindigkeit von 20 m/min läuft, unter den Lampen hergeführt, bis eine wischfeste Lackoberfläche erreicht ist. Je geringer die Anzahl der Durchläufe, desto besser ist die Photoinitatorwirkung der getesteten Verbindung. Die Härte der Probe wird durch Messung der Pendelhärte nach König (DIN 53157) bestimmt. Je höher die Zahl der Sekunden, desto härter ist die getestete Probe. Die Vergilbung der Probe wird als Yellowness-Index nach ASTM D 1925-70 gemessen, einmal sofort nach der Belichtung und einmal nach 4 h weiterer Belichtung. Je kleiner der Wert, desto geringer ist die Vergilbung der Probe.

Die Ergebnisse sind der Tabelle 3 zu entnehmen.

**Tabelle 3:**

| Verbindung aus Beispiel Nr. | Wischfestigkeit [Anzahl der Durchläufe bei 20m/min] | Pendelhärte [s] | Yellowness Index | |
|---|---|---|---|---|
| | | | sofort | nach 4 H |
| 1 | 3 | 139 | 9,2 | 6,9 |
| 3 | 6 | 97 | 7,3 | 7,0 |
| 5 | 4 | 135 | 8,3 | 7,1 |
| 6 | 5 | 139 | 8,0 | 7,4 |
| 7 | 7 | - | 7,0 | 7,0 |

## Patentansprüche

1. Photopolymerisierbare Zusammensetzung enthaltend
(a) mindestens eine ethylenisch ungesättigte photopolymerisierbare Verbindung und
(b) als Photoinitiator mindestens eine Verbindung der Formel I 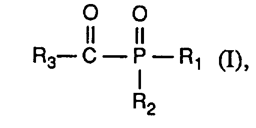 worin
R₁ für den Rest 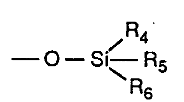 steht,
R₂ die gleiche Bedeutung wie R₁ hat, wobei R₁ und R₂ in der Bedeutung der Gruppen 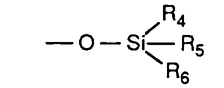 gleich oder verschieden sein können, oder R₂ C₁-C₁₈-Alkyl, durch Phenyl, C₁-C₁₂-Alkoxy oder Halogen substituiertes C₁-C₈-Alkyl, C₂-C₁₈-Alkenyl, unsubstituiertes oder durch C₁-C₁₂-Alkyl, C₁-C₁₂-Alkoxy, Phenyl oder Halogen substituiertes C₅-C₈-Cycloalkyl, unsubstituiertes oder durch Halogen, C₁-C₁₂-Alkyl oder C₁-C₁₂-Alkoxy substituiertes C₆-C₁₂-Aryl, ein aromatischer O-, S- oder/und N-haltiger 5- oder 6-gliedriger heterocyclischer Rest, welcher durch Halogen, C₁-C₄-Alkyl oder C₁-C₄-Alkoxy substituiert sein kann, C₁-C₁₂-Alkoxy, Phenoxy oder Benzyloxy ist und, falls R₂ für einen Rest 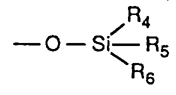 steht, R₆ die Siliziumatome zu 6-, 7- oder 8-gliedrigen Ringen verknüpfen kann, wodurch 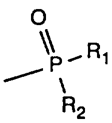 den Gruppen 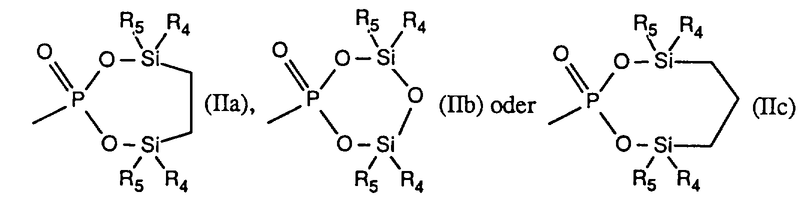 entspricht, oder R₁ und R₂ zusammen mit der -P=O-Gruppe einen 4-gliedrigen Ring der Formel 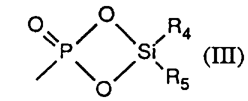 bilden können,
R₃ C₁-C₁₈-Alkyl, mit Halogen, Phenyl oder C₁-C₁₂-Alkoxy substituiertes C₁-C₈-Alkyl,
C₂-C₆-Alkenyl, unsubstituiertes oder durch C₁-C₁₂-Alkyl, C₁-C₁₂-Alkoxy oder Halogen substituiertes C₅-C₈-Cycloalkyl, unsubstituiertes oder durch C₁-C₁₂-Alkyl, C₁-C₁₂-Alkoxy, C₂-C₁₂-Alkoxyalkyl, C₁-C₄-Alkylthio oder Halogen substituiertes C₆-C₁₂-Aryl, oder einen 5- oder 6-gliedrigen aromarischen O-, S- oder/und N-haltigen heterocyclischen Rest, welcher durch Halogen, C₁-C₄-Alkyl oder C₁-C₄Alkoxy substituiert sein kann, bedeutet, und
R₄, R₅ und R₆ unabhängig voneinander für Wasserstoff, C₁-C₁₈-Alkyl, C₅-C₈-Cycloalkyl, C₁-C₁₂-Alkoxy oder unsubstituiertes oder mit C₁-C₈-Alkyl substituiertes Phenyl stehen, wobei mindestens zwei der Reste R₄, R₅ und R₆ eine andere Bedeutung als Wasserstoff haben.

2. Zusammensetzung nach Anspruch 1, worin R₂ die gleiche Bedeutung hat wie R₁, wobei
R₁ und R₂ in der Bedeutung der Gruppen 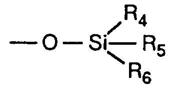 gleich oder verschieden sein können, oder R₂ für C₁-C₁₂-Alkyl, durch Phenyl, C₁-C₄- Alkoxy oder Halogen substituiertes C₁-C₈-Alkyl, C₂-C₈-Alkenyl, unsubstituiertes oder durch C₁-C₄-Alkyl, C₁-C₄-Alkoxy, Phenyl oder Halogen substituiertes C₅-C₈-Cycloalkyl, unsubstituiertes oder durch Halogen, C₁-C₈-Alkyl oder C₁-C₄-Alkoxy substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, C₁-C₈-Alkoxy, Phenoxy oder Benzyloxy steht, und, falls R₂ für einen Rest 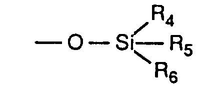 steht, R₆ die Siliziumatome zu 6-, 7- oder 8-gliedrigen Ringen verknüpfen kann, wodurch 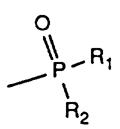 den Gruppen IIa, IIb oder IIc entsprechen kann, oder R₁ und R₂ zusammen mit der -P=O-Gruppe einen Ring der Formel III bilden können, R₃ C₁-C₁₂-Alkyl, mit Halogen, C₁-C₄-Alkoxy oder Phenyl substituiertes C₁-C₈-Alkyl, C₂-C₄-Alkenyl, unsubstituiertes oder durch C₁-C₈-Alkyl, C₁-C₄-Alkoxy oder Halogen substituiertes C₅-C₈-Cycloalkyl, unsubstituiertes oder durch C₁-C₈-Alkyl, C₁-C₈-Alkoxy, C₂-C₈-Alkoxyalkyl, C₁-C₄-Alkylthio oder Halogen substituiertes C₆-C₁₂-Aryl, oder einen 5- oder 6-gliedrigen aromarischen O-, S- oder/und N-haltigen heterocyclischen Rest, welcher durch Halogen, C₁-C₄-Alkyl oder C₁-C₄Alkoxy substituiert sein kann, bedeutet und R₄, R₅ und R₆ unabhängig voneinander für Wasserstoff, C₁-C₁₂-Alkyl,
C₅-C₈-Cycloalkyl, C₁-C₄-Alkoxy oder unsubstituiertes oder mit C₁-C₄-Alkyl substituiertes Phenyl stehen.

3. Zusammensetzung nach Anspruch 2, worin R₂ die gleiche Bedeutung hat wie R₁, wobei
R₁ und R₂ in der Bedeutung der Gruppen 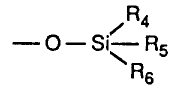 gleich oder verschieden sein können, oder R₂ für C₁-C₁₂-Alkyl, durch Phenyl substituiertes C₁-C₈-Alkyl,
C₅-C₈-Cycloalkyl, C₆-C₁₂-Aryl oder C₁-C₈-Alkoxy steht, und, falls R₂ für einen Rest 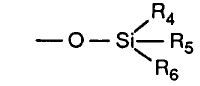 steht, R₆ die Siliziumatome zu einem 7-gliedrigen Ring verknüpfen kann, wodurch 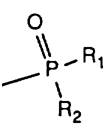 der Gruppe IIa entspricht,
R₃ C₁-C₁₂-Alkyl, mit Halogen substituiertes C₁-C₈-Alkyl, unsubstituiertes oder durch C₁-C₈-Alkyl substituiertes C₅-C₈-Cycloalkyl oder unsubstituiertes oder durch C₁-C₈-Alkyl, C₁-C₈-Alkoxy oder Halogen substituiertes C₆-C₁₂-Aryl bedeutet und R₄, R₅ und R₆ unabhängig voneinander für Wasserstoff, C₁-C₁₂-Alkyl, C₅-C₈-Cycloalkyl, oder unsubstituiertes oder mit C₁-C₄-Alkyl substituiertes Phenyl stehen.

4. Zusammensetzung nach Anspruch 3, worin R₂ die gleiche Bedeutung wie R₁ hat, wobei
R₁ und R₂ in der Bedeutung der Gruppen 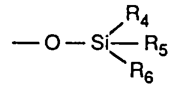 gleich oder verschieden sein können, oder R₂ für Phenyl, C₁-C₄-Alkoxy, unsubstituiertes oder durch Phenyl substituiertes C₁-C₄-Alkyl steht, oder, falls R₂ für einen Rest 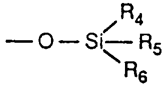 steht, R₆ die Siliziumatome zu einem Ring verknüpfen kann, wodurch 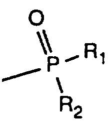 der Gruppe IIa entspricht, R₃ unsubstituiertes oder durch Halogen substituiertes C₁-C₄-Alkyl, unsubstituiertes oder durch C₁-C₆-Alkyl, C₁-C₄-Alkoxy oder Halogen substituiertes Phenyl bedeutet und R₄, R₅ und R₆ unabhängig voneinander für Wasserstoff, C₁-C₈-Alkyl, C₅-C₈-Cycloalkyl oder Phenyl stehen.

5. Zusammensetzung nach Anspruch 4, worin R₂ die gleiche Bedeutung wie R₁ hat, wobei
R₁ und R₂ in der Bedeutung der Gruppen 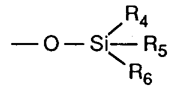 gleich oder verschieden sein können, oder R₂ für Phenyl steht, und, falls R₂ für einen Rest 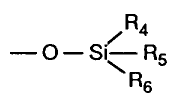 steht, R₆ die Siliziumatome zu einem 7-gliedrigen Ring verknüpfen kann, wodurch 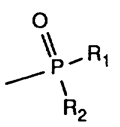 der Gruppe IIa entspricht, R₃ unsubstituiertes oder durch Halogen substituiertes C₁-C₄-Alkyl oder unsubstituiertes oder durch C₁-C₆-Alkyl, C₁-C₄-Alkoxy oder Halogen substituiertes Phenyl bedeutet und R₄, R₅ und R₆ unabhängig voneinander für C₁-C₈-Alkyl oder Phenyl stehen.

6. Zusammensetzung nach Anspruch 1, dadurch gekennzeichnet, dass sie neben dem Photoinitiator (b) noch mindestens einen weiteren Photoinitiator und/oder andere Additive enthält.

7. Zusammensetzung nach Anspruch 1, enthaltend 0,05 bis 15, insbesondere 0,2 bis 5 Gew.-% der Komponente (b), bezogen auf die Zusammensetzung.

8. Verbindungen der Formel Ia, die als Photoinitiatoren für die Polymerisation von Verbindungen mit ethylenisch ungesättigten Doppelbindungen geeignet sind 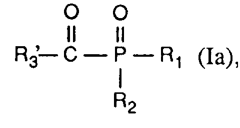 worin
R₁ für den Rest 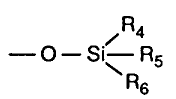 steht,
R₂ die gleiche Bedeutung wie R₁ hat, wobei R₁ und R₂ in der Bedeutung der Gruppen 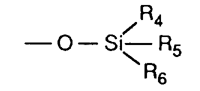 gleich oder verschieden sein können, oder R₂ C₁-C₁₈-Alkyl, durch Phenyl, C₁-C₁₂-Alkoxy oder Halogen substituiertes C₁-C₈-Alkyl, C₂-C₁₈-Alkenyl, unsubstituiertes oder durch C₁-C₁₂-Alkyl, C₁-C₁₂-Alkoxy, Phenyl oder Halogen substituiertes C₅-C₈-Cycloalkyl, unsubstituiertes oder durch Halogen, C₁-C₁₂-Alkyl oder C₁-C₁₂-Alkoxy substituiertes C₆-C₁₂-Aryl, ein aromatischer O-, S- oder/und N-haltiger 5- oder 6-gliedriger heterocyclischer Rest, welcher durch Halogen, C₁-C₄-Alkyl oder C₁-C₄-Alkoxy substituiert sein kann, oder Benzyloxy ist und, falls R₂ für einen Rest 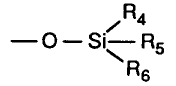 steht, R₆ die Siliziumatome zu 6-, 7- oder 8-gliedrigen Ringen verknüpfen kann, wodurch 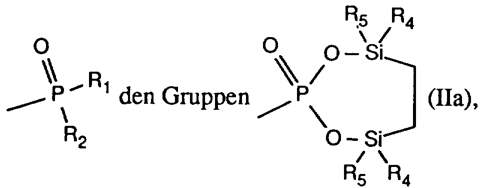 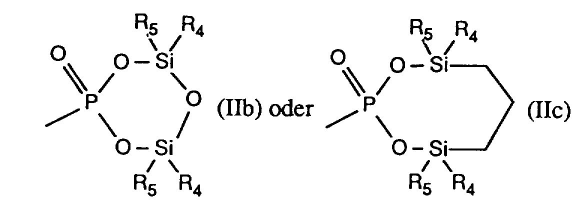 entspricht, oder R₁ und R₂ zusammen mit der -P=O-Gruppe einen 4-gliedrigen Ring der Formel 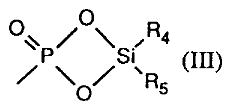 bilden können,
R₃ ^{,} C₁-C₁₈-Alkyl, mit Halogen, oder C₁-C₁₂-Alkoxy substituiertes C₁-C₈-Alkyl, C₂-C₆-Alkenyl, unsubstituiertes oder durch C₁-C₁₂-Alkyl, C₁-C₁₂-Alkoxy oder Halogen substituiertes C₅-C₈-Cycloalkyl, unsubstituiertes oder durch C₁-C₁₂-Alkyl, C₁-C₁₂-Alkoxy, C₂-C₁₂-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet, und
R₄, R₅ und R₆ unabhängig voneinander für Wasserstoff, C₁-C₁₈-Alkyl, C₅-C₈-Cycloalkyl, C₁-C₁₂-Alkoxy oder unsubstituiertes oder durch C₁-C₈-Alkyl substituiertes Phenyl stehen, wobei mindestens zwei der Reste R₄, R₅ und R₆ eine andere Bedeutung als Wasserstoff haben,
mit den Massgaben, dass, (1) wenn R₁ und R₂ gleich sind und R₄, R₅ und R₆ die gleiche Bedeutung haben und für Methyl oder Ethyl stehen, R₃' nicht C₁-C₅-Alkyl, Phenyl, Methyl-, Methoxy- oder Halogenphenyl ist, und (2) wenn R₃' für Methyl steht R₄, R₅ und R₆ im Rest R₁ nicht gleichzeitig Ethyl bedeuten.

9. Verbindungen nach Anspruch 8, worin R₂ die gleiche Bedeutung wie R₁ hat, wobei R₁ und R₂ in der Bedeutung der Gruppen 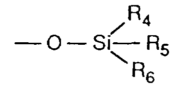 gleich oder verschieden sein können, oder R₂ für C₁-C₁₂-Alkyl, durch Phenyl, C₁-C₄- Alkoxy oder Halogen substituiertes C₁-C₈-Alkyl, C₂-C₈-Alkenyl, unsubstituiertes oder durch C₁-C₄-Alkyl, C₁-C₄-Alkoxy, Phenyl oder Halogen substituiertes C₅-C₈-Cycloalkyl, unsubstituiertes oder durch Halogen, C₁-C₈-Alkyl oder C₁-C₄-Alkoxy substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann oder Benzyloxy steht, und, falls R₂ für einen Rest 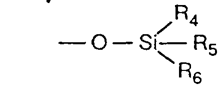 steht, R₆ die Siliziumatome zu 6-, 7- oder 8-gliedrigen Ringen verknüpfen kann, wodurch 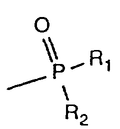 den Gruppen IIa, IIb oder IIc entsprechen kann, oder R₁ und R₂ zusammen mit der -P=O-Gruppe einen Ring der Formel III bilden können, R₃' C₁-C₁₂-Alkyl, mit Halogen, oder C₁-C₄-Alkoxy substituiertes C₁-C₈-Alkyl, C₂-C₄-Alkenyl, unsubstituiertes oder durch C₁-C₈-Alkyl, C₁-C₄-Alkoxy oder Halogen substituiertes C₅-C₈-Cycloalkyl, unsubstituiertes oder durch C₁-C₈-Alkyl, C₁-C₈-Alkoxy, C₂-C₈-Alkoxyalkyl, C₁-C₄-Alkylthio oder Halogen substituiertes C₆-C₁₂-Aryl, oder einen 5- oder 6-gliedrigen aromatischen O-, S- oder/und N-haltigen heterocyclischen Rest, welcher durch Halogen, C₁-C₄-Alkyl oder C₁-C₄Alkoxy substituiert sein kann, bedeutet und R₄, R₅ und R₆ unabhängig voneinander für Wasserstoff, C₁-C₁₂-Alkyl, C₅-C₈-Cycloalkyl, C₁-C₄-Alkoxy oder unsubstituiertes oder mit C₁-C₄-Alkyl substituiertes Phenyl stehen.

10. Verbindungen nach Anspruch 8, worin R₂ die gleiche Bedeutung hat wie R₁, wobei R₁ und R₂ in der Bedeutung der Gruppen 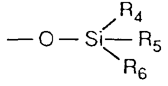 gleich oder verschieden sein können, oder R₂ für C₁-C₁₂-Alkyl, durch Phenyl substituiertes C₁-C₈-Alkyl,
C₅-C₈-Cycloalkyl, oder C₆-C₁₂-Aryl steht, und, falls R₂ für einen Rest 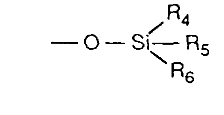 steht, R₆ die Siliziumatome zu einem 7-gliedrigen Ring verknüpfen kann, wodurch 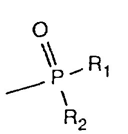 der Gruppe IIa entspricht,
R₃' C₁-C₁₂-Alkyl, mit Halogen substituiertes C₁-C₈-Alkyl, unsubstituiertes oder durch C₁-C₈-Alkyl substituiertes C₅-C₈-Cycloalkyl oder unsubstituiertes oder durch C₁-C₈-Alkyl, C₁-C₈-Alkoxy oder Halogen substituiertes C₆-C₁₂-Aryl bedeutet und R₄, R₅ und R₆ unabhängig voneinander für Wasserstoff, C₁-C₁₂-Alkyl, C₅-C₈-Cycloalkyl,
C₁-C₄-Alkoxy oder unsubstituiertes oder mit C₁-C₄-Alkyl substituiertes Phenyl stehen.

11. Verbindungen nach Anspruch 10, worin R₂ die gleiche Bedeutung wie R₁ hat, wobei
R₁ und R₂ in der Bedeutung der Gruppen 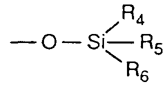 gleich oder verschieden sein können, oder R₂ für unsubstituiertes oder durch Phenyl substituiertes C₁-C₄-Alkyl oder Phenyl steht, oder, falls R₂ für einen Rest 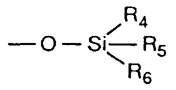 steht, R₆ die Siliziumatome zu einem 7-gliedrigen Ring verknüpfen kann, wodurch 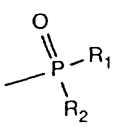 der Gruppe IIa entspricht, R₃' unsubstituiertes oder durch Halogen substituiertes C₁-C₄-Alkyl, unsubstituiertes oder durch C₁-C₆-Alkyl, C₁-C₄-Alkoxy oder Halogen substituiertes Phenyl bedeutet und R₄, R₅ und R₆ unabhängig voneinander für Wasserstoff, C₁-C₈-Alkyl oder Phenyl stehen.

12. Verbindungen nach Anspruch 11, worin R₂ die gleiche Bedeutung wie R₁ hat, wobei
R₁ und R₂ in der Bedeutung der Gruppen 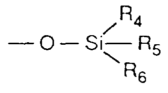 gleich oder verschieden sein können, oder R₂ für Phenyl steht, oder, falls R₂ für einen Rest 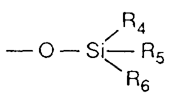 steht, R₆ die Siliziumatome zu einem 7-gliedrigen Ring verknüpfen kann, wodurch 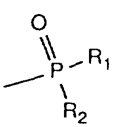 der Gruppe IIa entspricht, R₃' durch Halogen substituiertes C₁-C₄-Alkyl oder unsubstituiertes oder durch C₁-C₆-Alkyl oder Halogen substituiertes Phenyl bedeutet und R₄, R₅ und R₆ unabhängig voneinander für C₁-C₈-Alkyl oder Phenyl stehen.

13. Verwendung von Verbindungen der Formel I, wie in Anspruch 1 definiert, als Photoinitiatoren für die Photopolymerisation ethylenisch ungesättigter Verbindungen.

14. Verfahren zur Photopolymerisation von Verbindungen mit ethylenisch ungesättigten Doppelbindungen, dadurch gekennzeichnet, dass man eine Zusammensetzung gemäss Anspruch 1 mit Licht im Bereich von 200 bis 600 nm bestrahlt.

## Claims

1. A photopolymerisable composition comprising
(a) at least one ethylenically unsaturated, photopolymerisable compound and
(b) as photoinitiator at least one compound of the formula I 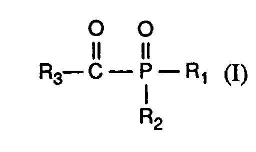 in which
R₁ is the 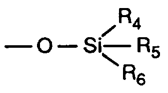 radical,
R₂ is as defined for R₁, it being possible for R₁ and R₂ as 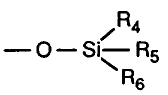 groups to be identical or different, or R₂ is C₁-C₁₈alkyl, phenyl-, C₁-C₁₂alkoxy- or halogen-substituted C₁-C₈alkyl, C₂-C₁₈alkenyl, unsubstituted or C₁-C₁₂alkyl-, C₁-C₁₂alkoxy-, phenyl- or halogen-substituted C₅-C₈cycloalkyl, unsubstituted or halogen-, C₁-C₁₂alkyl- or C₁-C₁₂alkoxy-substituted C₆-C₁₂aryl, an aromatic, O-, S- and/or N-containing 5- or 6-membered heterocyclic radical, which may be substituted by halogen, C₁-C₄alkyl or C₁-C₄alkoxy, or is C₁-C₁₂alkoxy, phenoxy or benzyloxy, and, if R₂ is a 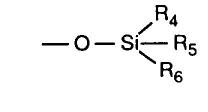 radical, R₆ can link the silicon atoms to form 6-, 7- or 8-membered rings, in which case 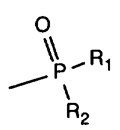 corresponds to the groups 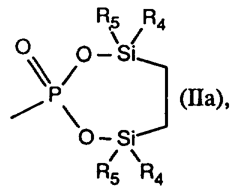 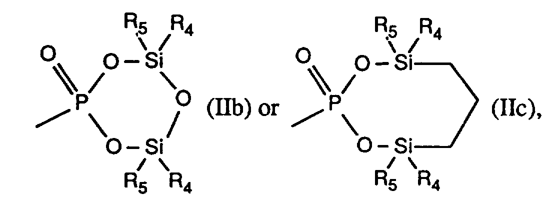 or R₁ and R₂, together with the -P=O group, can form a 4-membered ring of the formula 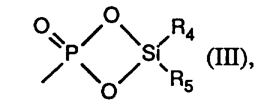
R₃ is C₁-C₁₈ahyl, halogen-, phenyl- or C₁-C₁₂alkoxy-substituted C₁-C₈alkyl, C₂-C₆alkenyl, unsubstituted or C₁-C₁₂alkyl-, C₁-C₁₂alkoxy- or halogen-substituted C₅-C₈cycloalkyl, unsubstituted or C₁-C₁₂alkyl-, C₁-C₁₂alkoxy-, C₂-C₁₂alkoxyaIkyl-, C₁-C₄alkylthio- or halogen-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy, and R₄, R₅ and R₆, independently of one another, are hydrogen, C₁-C₁₈ahyl, C₅-C₈cycloalkyl, C₁-C₁₂alkoxy or unsubstituted or C₁-C₈ahyl-substituted phenyl, at least two of the radicals R₄, R₅ and R₆ being other than hydrogen.

2. A composition according to claim 1, in which R₂ is as defined for R₁, it being possible for R₁ and R₂ as 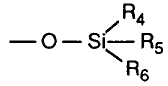 groups to be identical or different, or R₂ is
C₁-C₁₂alkyl, phenyl-, C₁-C₄alkoxy- or halogen-substituted C₁-C₈alkyl, C₂-C₈alkenyl, unsubstituted or C₁-C₄alkyl-, C₁-C₄alkoxy-, phenyl- or halogen-substituted C₅-C₈cycloalkyl, unsubstituted or halogen-, C₁ -C₈alkyl- or C₁-C₄alkoxy-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy, or is C₁-C₈alkoxy, phenoxy or benzyloxy, and, if R₂ is a 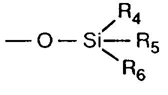 radical, R₆ can link the silicon atoms to form 6-, 7- or 8-membered rings, in which case 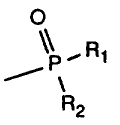 can correspond to the groups IIa, IIb or IIc,
or R₁ and R₂, together with the -P=O group, can form a ring of the formula III, R₃ is C₁-C₁₂alkyl, halogen-, C₁-C₄alkoxy- or phenyl-substituted C₁-C₈alkyl, C₂-C₄alkenyl, unsubstituted or C₁-C₈alkyl-, C₁-C₄alkoxy- or halogen-substituted C₅-C₈cycloalkyl, unsubstituted or C₁-C₈alkyI-, C₁-C₈alkoxy-, C₂-C₈alkoxyalkyl-, C₁-C₄alkyIthio- or halogen-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy, and R₄, R₅ and R₆, independently of one another, are hydrogen, C₁-C₁₂alkyl, C₅-C₈cycloalkyl, C₁-C₄alkoxy or unsubstituted or C₁-C₄alkyl-substituted phenyl.

3. A composition according to claim 2, in which R₂ is as defined for R₁, it being possible for R₁ and R₂ as 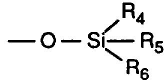 groups to be identical or different, or R₂ is C₁-C₁₂alkyl, phenyl-substituted C₁-C₈alkyl, C₅-C₈cydoalkyl, C₆-C₁₂aryl or C₁-C₈alkoxy, and, if R₂ is a 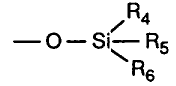 radical, R₆ can link the silicon atoms to form a 7-membered ring, in which case 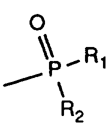 corresponds to the group IIa,
R₃ is C₁-C₁₂alkyl, halogen-substituted C₁-C₈alkyl, unsubstituted or C₁-C₈alkyl-substituted C₅-C₈cycloalkyl, or unsubstituted or C₁-C₈alkyl-, C₁-C₈alkoxy- or halogen-substituted C₆-C₁₂aryl, and R₄, R₅ and R₆, independently of one another, are hydrogen, C₁-C₁₂alkyl, C₅-C₈cycloalkyl or unsubstituted or C₁-C₄alkyl-substituted phenyl.

4. A composition according to claim 3, in which R₂ is as defined for R₁, it being possible for R₁ and R₂ as 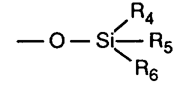 groups to be identical or different, or R₂ is phenyl, C₁-C₄alkoxy, unsubstituted or phenyl-substituted C₁-C₄alkyl, or, if R₂ is a 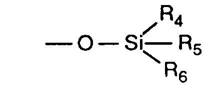 radical, R₆ can link the silicon atoms to form a ring, in which case 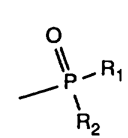 corresponds to the group IIa, R₃ is unsubstituted or halogen-substituted
C₁-C₄alkyl, unsubstituted or C₁-C₆alkyl-, C₁-C₄alkoxy- or halogen-substituted phenyl, and R₄, R₅ and R₆, independently of one another, are hydrogen, C₁-C₈alkyl, C₅-C₈cycloalkyl or phenyl.

5. A composition according to claim 4, in which R₂ is as defined for R₁, it being possible for R₁ and R₂ as 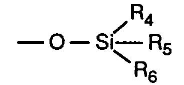 groups to be identical or different, or R₂ is phenyl, and, if R₂ is a 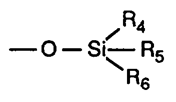 radical, R₆ can link the silicon atoms to form a 7-membered ring, in which case 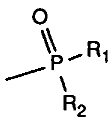 corresponds to the group IIa, R₃ is unsubstituted or halogen-substituted C₁-C₄alkyl or unsubstituted or C₁-C₆alkyl-, C₁-C₄alkoxy- or halogen-substituted phenyl, and R₄, R₅ and R₆, independently of one another, are C₁-C₈alkyl or phenyl.

6. A composition according to claim 1, which comprises, in addition to the photoinitiator (b), at least one further photoinitiator and/or other additives.

7. A composition according to claim 1, comprising from 0.05 to 15 % by weight, in particular from 0.2 to 5 % by weight, of component (b), based on the composition.

8. A compound of the formula Ia which is suitable as a photoinitiator for the polymerisation of compounds containing ethylenically unsaturated double bonds, 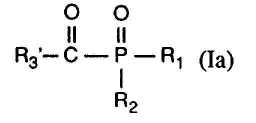 in which
R₁ is the 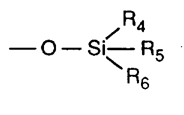 radical,
R₂ is as defined for R₁, it being possible for R₁ and R₂ as 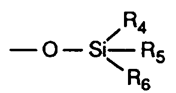 groups to be identical or different, or R₂ is C₁-C₁₈alkyl, phenyl-, C₁-C₁₂alkoxy- or halogen-substituted C₁-C₈alkyl, C₂-C₁₈alkenyl, unsubstituted or C₁-C₁₂alkyl-, C₁-C₁₂alkoxy-, phenyl- or halogen-substituted C₅-C₈cycloalkyl, unsubstituted or halogen-, C₁-C₁₂alkyl- or C₁-C₁₂alkoxy-substituted C₆-C₁₂aryl, an aromatic, O-, S- and/or N-containing 5- or 6-membered heterocyclic radical, which may be substituted by halogen, C₁-C₄alkyl or C₁-C₄alkoxy, or is benzyloxy, and, if R₂ is a 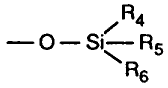 radical, R₆ can link the silicon atoms to form 6-, 7- or 8-membered rings, in which case 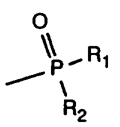 corresponds to the groups 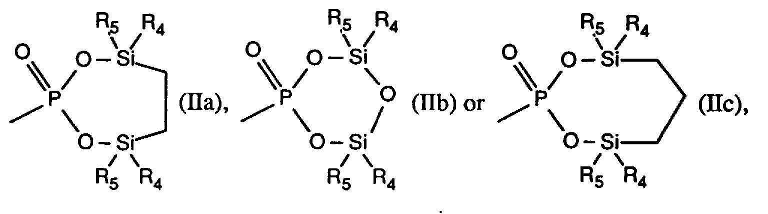 or R₁ and R₂, together with the -P=O group, can form a 4-membered ring of the formula 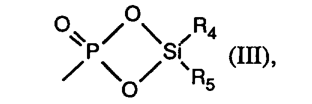
R₃' is C₁-C₁₈alkyl, halogen- or C₁-C₁₂alkoxy-substituted C₁-C₈alkyl, C₂-C₆alkenyl, unsubstituted or C₁-C₁₂alkyl-, C₁-C₁₂alkoxy- or halogen-substituted C₅-C₈cycloalkyl, unsubstituted or C₁-C₁₂alkyl-, C₁-C₁₂alkoxy-, C₂-C₁₂alkoxyalkyl-, C₁-C₄alkylthio- or halogen-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy, and R₄, R₅ and R₅, independently of one another, are hydrogen, C₁-C₁₈alkyl, C₅-C₈cycloalkyl, C₁-C₁₂alkoxy or unsubstituted or C₁-C₈alkyl-substituted phenyl, at least two of the radicals R₄, R₅ and R₆ being other than hydrogen,
with the provisos that (1) if R₁ and R₂ are identical and R₄, R₅ and R₆ have the same meanings and are methyl or ethyl, R₃' is not C₁-C₅alkyl, phenyl, methylphenyl, methoxyphenyl or halophenyl and (2) if R₃' is methyl, R₄, R₅ and R₆ in the radical R₁ are not simultaneously ethyl.

9. A compound according to claim 8, in which R₂ is as defined for R₁, it being possible for R₁ and R₂ as 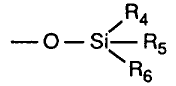 groups to be identical or different, or R₂ is C₁-C₁₂alkyl, phenyl-, C₁-C₄alkoxy- or halogen-substituted C₁-C₈alkyl, C₂-C₈alkenyl, unsubstituted or C₁-C₄alkyl-, C₁-C₄alkoxy-, phenyl- or halogen-substituted C₅-C₈cycloalkyl, unsubstituted or halogen-, C₁-C₈alkyl- or C₁-C₄alkoxy-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy - or is benzyloxy, and, if R₂ is a 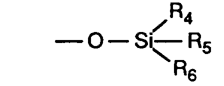 radical, R₆ can link the silicon atoms to form 6-, 7- or 8-membered rings, in which case 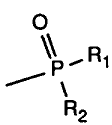 can correspond to the groups IIa, IIb or IIc,
or R₁ and R₂, together with the -P=O group, can form a ring of the formula III, R₃' is C₁-C₁₂alkyl, halogen- or C₁-C₄alkoxy-substituted C₁-C₈alkyl, C₂-C₄alkenyl, unsubstituted or C₁-C₈alkyl-, C₁-C₄alkoxy- or halogen-substituted C₅-C₈cycloalkyl, unsubstituted or C₁-C₈alkyl-, C₁-C₈alkoxy-, C₂-C₈alkoxyalkyl-, C₁-C₄alkylihio- or halogen-substituted C₆-C₁₂aryl, or a 5- or 6-membered, aromatic, O-, S- and/or N-containing heterocyclic radical, which may be substituted by halogen, C₁-C₄alkyl or C₁-C₄alkoxy, and R₄, R₅ and R₆, independently of one another, are hydrogen, C₁-C₁₂alkyl, C₅-C₈cycloalkyl, C₁-C₄alkoxy or unsubstituted or C₁-C₄alkyl-substituted phenyl.

10. A compound according to claim 8, in which R₂ is as defined for R₁, it being possible for R₁ and R₂ as 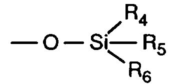 groups to be identical or different, or R₂ is C₁-C₁₂alkyl, phenyl-substituted C₁-C₈alkyl, C₅-C₈cycloalkyl or C₆-C₁₂aryl, and, if R₂ is a 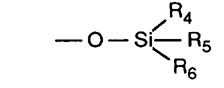 radical, R₆ can link the silicon atoms to form a 7-membered ring, in which case 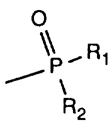 corresponds to the group IIa,
R₃' is C₁-C₁₂alkyl, halogen-substituted C₁-C₈alkyl, unsubstituted or
C1-C8alkyl-substituted C₅-C₈cycloalkyl, or unsubstituted or C₁-C₈alkyl-, C₁-C₈alkoxy- or halogen-substituted C₆-C₁₂aryl, and R₄, R₅ and R₆, independently of one another, are hydrogen, C₁-C₁₂alkyl, C₅-C₈cycloalkyl, C₁-C₄alkoxy or unsubstituted or C₁-C₄alkyl-substituted phenyl.

11. A compound according to claim 10, in which R₂ is as defined for R₁, it being possible for R₁ and R₂ as 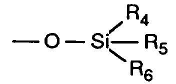 groups to be identical or different, or R₂ is unsubstituted or phenyl-substituted C₁-C₄alkyl or phenyl, and, if R₂ is a 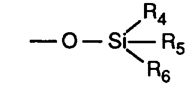 radical, R₆ can link the silicon atoms to form a 7-membered ring, in which case 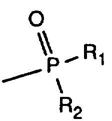 corresponds to the group IIa, R₃' is unsubstituted or halogen-substituted C₁-C₄alkyl, unsubstituted or C₁-C₆alkyl-, C₁-C₄alkoxy- or halogen-substituted phenyl, and R₄, R₅ and R₆, independently of one another, are hydrogen, C₁-C₈alkyl or phenyl.

12. A compound according to claim 11, in which R₂ is as defined for R₁, it being possible for R₁ and R₂ as 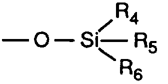 groups to be identical or different, or R₂ is phenyl, and, if R₂ is a 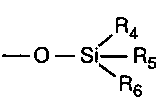 radical, R₆ can link the silicon atoms to form a 7-membered ring, in which case 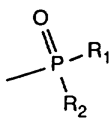 corresponds to the group IIa, R₃' is halogen-substituted C₁-C₄alkyl or unsubstituted or C₁-C₆alkyl- or halogen-substituted phenyl, and R₄, R₅ and R₆, independently of one another, are C₁-C₈alkyl or phenyl.

13. The use of a compound of the formula I as defined in claim 1 as a photoinitiator for the photopolymerisation of ethylenically unsaturated compounds.

14. A process for the photopolymerisation of compounds containing ethylenically unsaturated double bonds, which comprises irradiating a composition according to claim 1 with light in the range from 200 to 600 nm.

## Revendications

1. Composition photopolymérisable contenant
(a) au moins un composé photopolymérisable à insaturation éthylénique et
(b) comme photoamorceur, au moins un composé de formule I 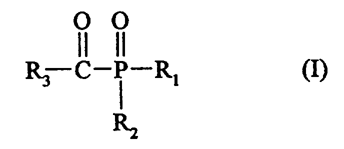 dans laquelle
R₁ représente le reste 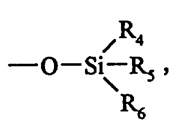
R₂ a la même signification que R₁, R₁ et R₂ pouvant être identiques ou différents lorsqu'ils représentent des groupes 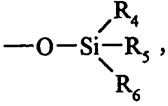 ou bien R₂ est un reste alkyle en C₁-C₁₈, un reste alkyle en C₁-C₈ substitué par phényle, alcoxy en C₁-C₁₂ ou halogène, un reste alcényle en C₂-C₁₈, un reste cycloalkyle en C₅-C₈ non substitué ou substitué par alkyle en C₁-C₁₂ alcoxy en en C₁-C₁₂, phényle ou halogène, un reste aryle en C₆-C₁₂ non substitué ou substitué par halogène, alkyle en C₁-C₁₂ ou alcoxy en C₁-C₁₂, un reste hétérocyclique aromatique de 5 ou 6 chaînons contenant O, S ou/et N, qui peut être substitué par halogène, alkyle en C₁-C₄ ou alcoxy en C₁-C₄, un reste alcoxy en C₁-C₁₂, reste phénoxy ou un reste benzyloxy, et, dans le cas où R₂ représente un reste 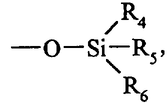 R₆ peut relier les atomes de silicium pour former des cycles de 6, 7 ou 8 chaînons, de façon que 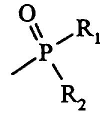 corresponde aux groupes 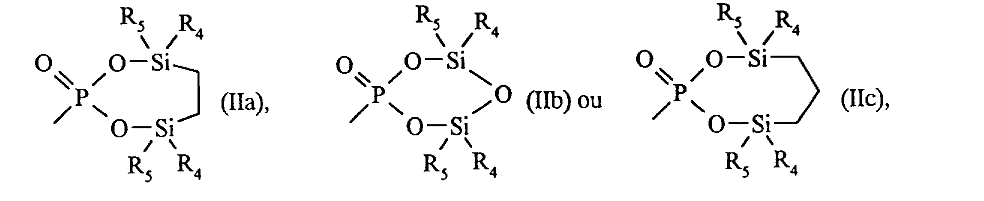 ou bien R₁ et R₂ peuvent former ensemble avec le groupe -P=O un cycle à quatre chaînons de formule 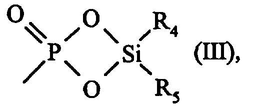
R₃ représente un reste alkyle en C₁-C₁₈, un reste alkyle en C₁-C₈ substitué par halogène, phényle ou alcoxy en C₁-C₁₂, un reste alcényle en C₂-C₆, un reste cycloalkyle en C₅-C₈ non substitué ou substitué par alkyle en C₁-C₁₂ alcoxy en C₁-C₁₂ ou halogène, un reste aryle en C₆-C₁₂ non substitué ou substitué par alkyle en C₁-C₁₂ alcoxy en C₁-C₁₂, alcoxyalkyle en C₂-C₁₂, alkylthio en C₁-C₄ ou halogène, ou un reste hétérocyclique aromatique de 5 ou 6 chaînons contenant O, S ou/et N, qui peut être substitué par halogène, alkyle en C₁-C₄ ou alcoxy en C₁-C₄, et
R₄, R₅ et R₆ représentent indépendamment les uns des autres un atome d'hydrogène, un reste alkyle en C₁-C₁₈, un reste cycloalkyle en C₅-C₈, un reste alcoxy en C₁-C₁₂ ou un reste phényle non substitué ou substitué par alkyle en C₁-C₈, au moins deux des restes R₄, R₅ et R₆ étant différents de l'hydrogène.

2. Composition selon la revendication 1, dans laquelle R₂ a la même signification que R₁, R₁ et R₂ pouvant être identiques ou différents lorsqu'ils représentent des groupes 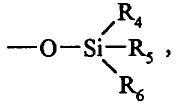 ou bien R₂ représente un reste alkyle en C₁-C₁₂, un reste alkyle en C₁-C₈ substitué par phényle, alcoxy en C₁-C₄ ou halogène, un reste alcényle en C₂-C₈, un reste cycloalkyle en C₅-C₈ non substitué ou substitué par alkyle en C₁-C₄, alcoxy en C₁-C₄, phényle ou halogène, un reste aryle en C₆-C₁₂ non substitué ou substitué par halogène, alkyle en C₁-C₈ ou alcoxy en C₁-C₄, ou un reste hétérocyclique aromatique de 5 ou 6 chaînons contenant O, S ou/et N, qui peut être substitué par halogène, alkyle en C₁-C₄ ou alcoxy en C₁-C₄, un reste alcoxy en C₁-C₈, un reste phénoxy ou un reste benzyloxy, et, dans le cas où R₂ représente un reste 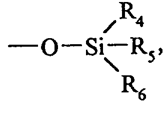 R₆ peut relier les atomes de silicium pour former des cycles de 6, 7 ou 8 chaînons, de façon que 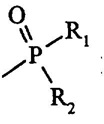 puisse correspondre aux groupes IIa, Ilb ou IIc, ou bien R₁ et R₂ peuvent former ensemble avec le groupe -P=O un cycle de formule (III),
R₃ représente un reste alkyle en C₁-C₁₂ un reste alkyle en C₁-C₈ substitué par halogène, alcoxy en C₁-C₄ ou phényle, un reste alcényle en C₂-C₄, un reste cycloalkyle en C₅-C₈ non substitué ou substitué par alkyle en C₁-C₈, alcoxy en C₁-C₄ ou halogène, un reste aryle en C₆-C₁₂ non substitué ou substitué par alkyle en C₁-C₈, alcoxy en C₁-C₈, alcoxyalkyle en C₂-C₈, alkylthio en C₁-C₄ ou halogène, ou un reste hétérocyclique aromatique de 5 ou 6 chaînons contenant O, S ou/et N, qui peut être substitué par halogène, alkyle en C₁-C₄ ou alcoxy en C₁-C₄, et
R₄, R₅ et R₆ représentent indépendamment les uns des autres un atome d'hydrogène, un reste alkyle en C₁-C₁₂ un reste cycloalkyle en C₅-C₈, un reste alcoxy en C₁-C₄ ou un reste phényle non substitué ou substitué par alkyle en C₁-C₄.

3. Composition selon la revendication 2, dans laquelle R₂ a la même signification que R₁, R₁ et R₂ pouvant être identiques ou différents lorsqu'ils représentent des groupes 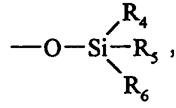 ou bien R₂ représente un reste alkyle en C₁-C₁₂, un reste alkyle en C₁-C₈ substitué par phényle, un reste cycloalkyle en C₅-C₈, un reste aryle en C₆-C₁₂ ou un reste alcoxy en C₁-C₈, et, dans le cas où R₂ représente un reste 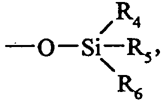 R₆ peut relier les atomes de silicium pour former un cycle de 7 chaînons, de façon que 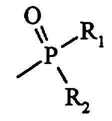 corresponde au groupe IIa, R₃ représente un reste alkyle en C₁-C₁₂, un reste alkyle en C₁-C₈ substitué par halogène, un reste cycloalkyle en C₅-C₈ non substitué ou substitué par alkyle en C₁-C₈, ou un reste aryle en C₆-C₁₂ non substitué ou substitué par alkyle en C₁-C₈, alcoxy en C₁-C₈ ou halogène, et R₄, R₅ et R₆ représentent indépendamment les uns des autres un atome d'hydrogène, un reste alkyle en C₁-C₁₂ un reste cycloalkyle en C₅-C₈, ou un reste phényle non substitué ou substitué par alkyle en C₁-C₄.

4. Composition selon la revendication 3, dans laquelle R₂ a la même signification que R₁, R₁ et R₂ pouvant être identiques ou différents lorsqu'ils représentent des groupes 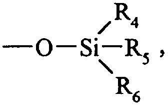 ou bien R₂ représente un reste phényle, un reste alcoxy en C₁-C₄, un reste alkyle en C₁-C₄ non substitué ou substitué par phényle, ou, dans le cas où R₂ représente un reste 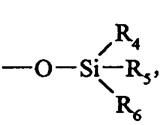 R₆ peut relier les atomes de silicium pour former un cycle, de façon que 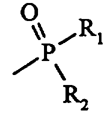 corresponde au groupe IIa, R₃ représente un reste alkyle en C₁-C₄ non substitué ou substitué par halogène ou un reste phényle non substitué ou substitué par alkyle en C₁-C₆, alcoxy en C₁-C₄ ou halogène, et R₄, R₅ et R₆ représentent indépendamment les uns des autres un atome d'hydrogène, un reste alkyle en C₁-C₈, un reste cycloalkyle en C₅-C₈ ou un reste phényle.

5. Composition selon la revendication 4, dans laquelle R₂ a la même signification que R₁, R₁ et R₂ pouvant être identiques ou différents lorsqu'ils représentent des groupes 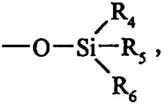 ou bien R₂ représente un reste phényle ou, dans le cas où R₂ représente un reste 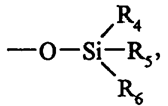 R₆ peut relier les atomes de silicium pour former un cycle de 7 chaînons, de façon que 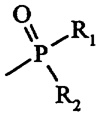 corresponde au groupe IIa, R₃ représente un reste alkyle en C₁-C₄ non substitué ou substitué par halogène ou un reste phényle non substitué ou substitué par alkyle en C₁-C₆, alcoxy en C₁-C₄ ou halogène, et R₄, R₅ et R₆ représentent indépendamment les uns des autres un reste alkyle en C₁-C₈ ou un reste phényle.

6. Composition selon la revendication 1, caractérisée en ce que, en plus du photoamorceur (b), elle contient au moins un autre photoamorceur et/ou d'autres additifs.

7. Composition selon la revendication 1, contenant de 0,05 à 15 % en masse, en particulier de 0,2 à 5 % en masse de constituant (b) par rapport à la composition.

8. Composés de formule Ia, qui conviennent comme photoamorceurs pour la polymérisation de composés à doubles liaisons insaturées éthyléniques, 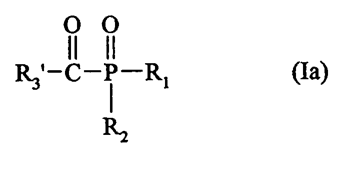 dans lesquels
R₁ représente le reste 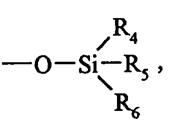
R₂ a la même signification que R₁, R₁ et R₂ pouvant être identiques ou différents lorsqu'ils représentent des groupes 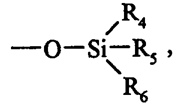 ou bien R₂ est un reste alkyle en C₁-C₁₈, un reste alkyle en C₁-C₈ substitué par phényle, alcoxy en C₁-C₁₂ ou halogène, un reste alcényle en C₂-C₁₈, un reste cycloalkyle en C₅-C₈ non substitué ou substitué par alkyle en C₁-C₁₂ alcoxy en en C₁-C₁₂ phényle ou halogène, un reste aryle en C₆-C₁₂ non substitué ou substitué par halogène, alkyle en C₁-C₁₂ ou alcoxy en C₁-C₁₂ un reste hétérocyclique aromatique de 5 ou 6 chaînons contenant O, S ou/et N, qui veut être substitué par halogène, alkyle en C₁-C₄ ou alcoxy en C₁-C₄, ou un reste benzyloxy, et, dans le cas où R₂ représente un reste 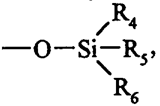 R₆ peut relier les atomes de silicium pour former des cycles de 6, 7 ou 8 chaînons, de façon que 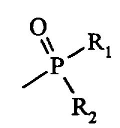 corresponde aux groupes 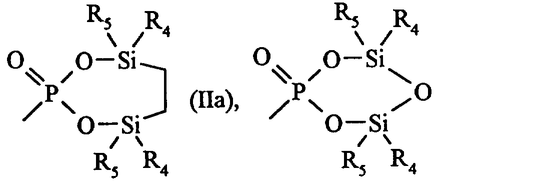 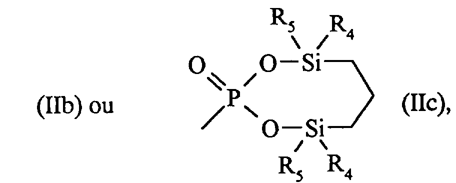 ou bien R₁ et R₂ peuvent former ensemble avec le groupe -P=O un cycle à quatre chaînons de formule 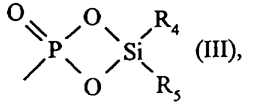
R₃' représente un reste alkyle en C₁-C₁₈, un reste alkyle en C₁-C₈ substitué par halogène ou alcoxy en C₁-C₁₂, un reste alcényle en C₂-C₆, un reste cycloalkyle en C₅-C₈ non substitué ou substitué par alkyle en C₁-C₁₂, alcoxy en C₁-C₁₂ ou halogène, un reste aryle en C₆-C₁₂ non substitué ou substitué par alkyle en C₁-C_{12,} alcoxy en C₁-C₁₂, alcoxyalkyle en C₂-C₁₂, alkylthio en C₁-C₄ ou halogène, ou un reste hétérocyclique aromatique de 5 ou 6 chaînons contenant O, S ou/et N, qui peut être substitué par halogène, alkyle en C₁-C₄ ou alcoxy en C₁-C₄, et
R₄, R₅ et R₆ représentent indépendamment les uns des autres un atome d'hydrogène, un reste alkyle en C₁-C₁₈, un reste cycloalkyle en C₅-C₈, un reste alcoxy en C₁-C₁₂ ou un reste phényle non substitué ou substitué par alkyle en C₁-C₈, au moins deux des restes R₄, R₅ et R₆ étant différents de l'hydrogène,
à condition que (1), lorsque R₁ et R₂ sont identiques et que R₄, R₅ et R₆ ont la même signification et représentent des restes méthyle ou éthyle, R₃' soit différent d'un reste alkyle en C₁-C₅, phényle, méthylphényle, méthoxyphényle ou halogénophényle, et que (2), lorsque R₃' est un reste méthyle, R₄, R₅ et R₆ dans le reste R₁ ne soient pas en même temps un reste éthyle.

9. Composés selon la revendication 8, dans lesquels R₂ a la même signification que R₁, R₁ et R₂ pouvant être identiques ou différents lorsqu'ils représentent des groupes 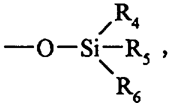 ou bien R₂ représente un reste alkyle en C₁-C₁₂ un reste alkyle en C₁-C₈ substitué par phényle, alcoxy en C₁-C₄ ou halogène, un reste alcényle en C₂-C₈, un reste cycloalkyle en C₅-C₈ non substitué ou substitué par alkyle en C₁-C₄, alcoxy en C₁-C₄, phényle ou halogène, un reste aryle en C₆-C₁₂ non substitué ou substitué par halogène, alkyle en C₁-C₈ ou alcoxy en C₁-C₄, ou un reste hétérocyclique aromatique de 5 ou 6 chaînons contenant O, S ou/et N, qui peut être substitué par halogène, alkyle en C₁-C₄ ou alcoxy en C₁-C₄, ou un reste benzyloxy, et, dans le cas où R₂ représente un reste 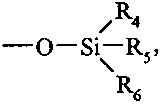 R₆ peut relier les atomes de silicium pour former des cycles de 6, 7 ou 8 chaînons, de façon que 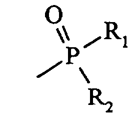 puisse correspondre aux groupes IIa, IIb ou IIc ou bien R₁ et R₂ peuvent former ensemble avec le groupe -P=O un cycle de formule (III),
R₃' représente un reste alkyle en C₁-C₁₂, un reste alkyle en C₁-C₈ substitué par halogène ou alcoxy en C₁-C₄, un reste alcényle en C₂-C₄, un reste cycloalkyle en C₅-C₈ non substitué ou substitué par alkyle en C₁-C₈, alcoxy en C₁-C₄ ou halogène, un reste aryle en C₆-C₁₂ non substitué ou substitué par alkyle en C₁-C₈, alcoxy en C₁-C₈, alcoxyalkyle en C₂-C₈, alkylthio en C₁-C₄ ou halogène, ou un reste hétérocyclique aromatique de 5 ou 6 chaînons contenant O, S ou/et N, qui peut être substitué par halogène, alkyle en C₁-C₄ ou alcoxy en C₁-C₄, et
R₄, R₅ et R₆ représentent indépendamment les uns des autres un atome d'hydrogène, un reste alkyle en C₁-C_{12,} un reste cycloalkyle en C₅-C₈, un reste alcoxy en C₁-C₄ ou un reste phényle non substitué ou substitué par alkyle en C₁-C₄.

10. Composés selon la revendication 8, dans lesquels R₂ a la même signification que R₁, R₁ et R₂ pouvant être identiques ou différents lorsqu'ils représentent des groupes 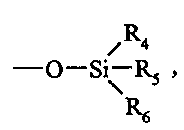 ou bien R₂ représente un reste alkyle en C₁-C₁₂, un reste alkyle en C₁-C₈ substitué par phényle, un reste cycloalkyle en C₅-C₈ ou un reste aryle en C₆-C₁₂, et, dans le cas où R₂ représente un reste 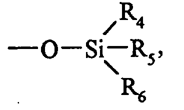 R₆ peut relier les atomes de silicium pour former un cycle de 7 chaînons, de façon que 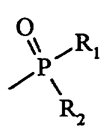 corresponde au groupe IIa, R₃' représente un reste alkyle en C₁-C₁₂, un reste alkyle en C₁-C₈ substitué par halogène, un reste cycloalkyle en C₅-C₈ non substitué ou substitué par alkyle en C₁-C₈, ou un reste aryle en C₆-C₁₂ non substitué ou substitué par alkyle en C₁-C₈, alcoxy en C₁-C₈ ou halogène, et R₄, R₅ et R₆ représentent indépendamment les uns des autres un atome d'hydrogène, un reste alkyle en C₁-C₁₂, un reste cycloalkyle en C₅-C₈, un reste alcoxy en C₁-C₄ ou un reste phényle non substitué ou substitué par alkyle en C₁-C₄.

11. Composés selon la revendication 10, dans lesquels R₂ a la même signification que R₁, R₁ et R₂ pouvant être identiques ou différents lorsqu'ils représentent des groupes 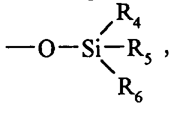 ou bien R₂ représente un reste alkyle en C₁-C₄ non substitué ou substitué par phényle ou un reste phényle, ou, dans le cas où R₂ représente un reste 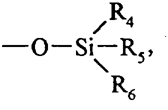 R₆ peut relier les atomes de silicium pour former un cycle de 7 chaînons, de façon que 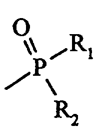 corresponde au groupe IIa, R₃' représente un reste alkyle en C₁-C₄ non substitué ou substitué par halogène ou un reste phényle non substitué ou substitué par alkyle en C₁-C₆, alcoxy en C₁-C₄ ou halogène, et R₄, R₅ et R₆ représentent indépendamment les uns des autres un atome d'hydrogène, un reste alkyle en C₁-C₈ ou un reste phényle.

12. Composés selon la revendication 11, dans lesquels R₂ a la même signification que R₁, R₁ et R₂ pouvant être identiques ou différents lorsqu'ils représentent des groupes 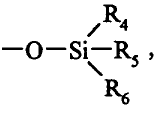 ou bien R₂ représente un reste phényle ou, dans le cas où R₂ représente un reste 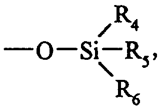 R₆ peut relier les atomes de silicium pour former un cycle de 7 chaînons, de façon que 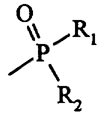 corresponde au groupe IIa, R₃' représente un reste alkyle en C₁-C₄ substitué par halogène ou un reste phényle non substitué ou substitué par alkyle en C₁-C₆ ou halogène, et R₄, R₅ et R₆ représentent indépendamment les uns des autres un reste alkyle en C₁-C₈ ou un reste phényle.

13. Utilisation des composés de formule I tels que définis dans la revendication 1 comme photoamorceurs pour la photopolymérisation de composés à insaturation éthylénique.

14. Procédé de photopolymérisation de composés à doubles liaisons insaturées éthyléniques, caractérisé en ce que l'on expose une composition selon la revendication 1 à de la lumière dans la gamme de 200 à 600 nm.
